# EUROPEAN PATENT SPECIFICATION

(11) **EP 4 546 406 B1**
(45) Date of publication and mention of the grant of the patent: **18.03.2026**
(21) Application number: 24177621.0
(22) Date of filing: 23.05.2024
(51) Int. Cl.: H01L 21/768, H01L 23/522, H01L 23/528, H01L 23/532, H01L 23/48

(54) **SEMICONDUCTOR DEVICES AND METHODS OF FABRICATING THE SAME**
HALBLEITERBAUELEMENTE UND VERFAHREN ZU IHRER HERSTELLUNG
DISPOSITIFS SEMI-CONDUCTEURS ET LEURS PROCÉDÉS DE FABRICATION

(30) Priority: 24.10.2023 KR 20230143177
(43) Date of publication of application: 30.04.2025
(73) Proprietor: SAMSUNG ELECTRONICS CO., LTD., Yeongtong-gu Suwon-si, Gyeonggi-do 16677 (KR)
(72) Inventor: SHIN, Joongwon, 16677 Suwon-si, Gyeonggi-do (KR); HWANG, Sehyun, 16677 Suwon-si, Gyeonggi-do (KR); LEE, Jong-Min, 16677 Suwon-si, Gyeonggi-do (KR)
(74) Representative: Kuhnen & Wacker Patent- und Rechtsanwaltsbüro PartG mbB

(56) References cited:
- US-A1- 2004 183 162
- US-A1- 2010 059 887
- US-A1- 2021 351 123
- US-A1- 2023 080 862

## Description

The inventive concept relates to semiconductor devices and methods of fabricating the same.

Semiconductor devices are beneficial in the electronics industry because of their small size, multi-functionality, and/or low fabrication cost. However, semiconductor devices are being highly integrated with the remarkable development of the electronics industry. Line widths of patterns of semiconductor devices are being reduced for high integration thereof. New exposure techniques and/or expensive exposure techniques may be used for fine patterns to manufacture highly integrated semiconductor devices. Various studies have thus been conducted for new integration techniques.

US 2023/080862 A1 discloses a semiconductor device that includes a substrate, a transistor connected to the substrate, and a wiring structure including contact wirings electrically connected to the transistor. The wiring structure further includes a first wiring insulating layer, a first material layer contacting the first wiring insulating layer, a second material layer contacting the first material layer, and a second wiring insulating layer contacting the second material layer. The first material layer includes SiN, and the second material layer includes SiCN. A dielectric constant of the first wiring insulating layer is greater than a dielectric constant of the second wiring insulating layer.

### SUMMARY OF THE INVENTION

A semiconductor device according to the inventive concept is defined by claim 1. Further developments of a semiconductor device according to the inventive concept are defined by claims 2 to 11. A method of fabricating a semiconductor device according to the inventive concept is defined by claim 12.

A semiconductor device according to the inventive concept provides a semiconductor device with improved reliability.

A method of fabricating a semiconductor device according to the inventive concept is capable of increasing yield.

### BRIEF DESCRIPTION OF THE DRAWINGS

Example embodiments will be more clearly understood from the following brief description taken in conjunction with the accompanying drawings. The accompanying drawings represent non-limiting, example embodiments as described herein.
FIG. 1 is a cross-sectional view of a semiconductor device according to embodiments of the inventive concept.
FIG. 2A is an enlarged view of portion 'P1' of FIG. 1 according to embodiments of the inventive concept.
FIG. 2B is a plan view of a third M1 wiring of FIG. 2A according to embodiments of the inventive concept.
FIGS. 3A to 3M are cross-sectional views sequentially illustrating a method of fabricating the semiconductor device of FIG. 1 according to embodiments of the inventive concept.
FIGS. 4A to 4D are cross-sectional views sequentially illustrating a method of fabricating the semiconductor device of FIG. 1 according to embodiments of the inventive concept.
FIG. 5A is an enlarged view corresponding to portion 'P1' of FIG. 1 according to embodiments of the inventive concept.
FIG. 5B is a plan view of a third M1 wiring of FIG. 5A.
FIG. 6A is an enlarged view corresponding to portion 'P1' of FIG. 1 according to embodiments of the inventive concept.
FIG. 6B is a plan view of a third M1 wiring of FIG. 6A.
FIG. 7 is an enlarged view corresponding to portion 'P1' of FIG. 1 according to embodiments of the inventive concept.
FIG. 8 is a cross-sectional view of a semiconductor device according to embodiments of the inventive concept.
FIG. 9 is a plan view of a semiconductor device according to embodiments of the inventive concept.
FIG. 10 are cross-sectional views taken along lines R1-R1' and R2-R2' of FIG. 9 according to embodiments of the inventive concept.
FIG. 11 is a cross-sectional view of a semiconductor package according to embodiments of the inventive concept.

### DETAILED DESCRIPTION

Hereinafter, to explain the inventive concept in detail, embodiments according to the inventive concept will be described with reference to the accompanying drawings.

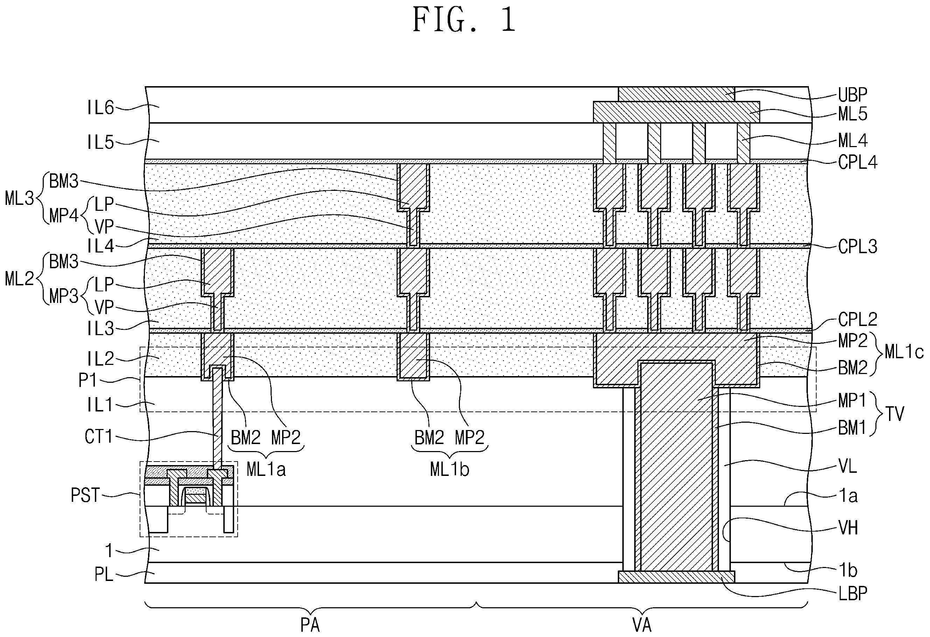

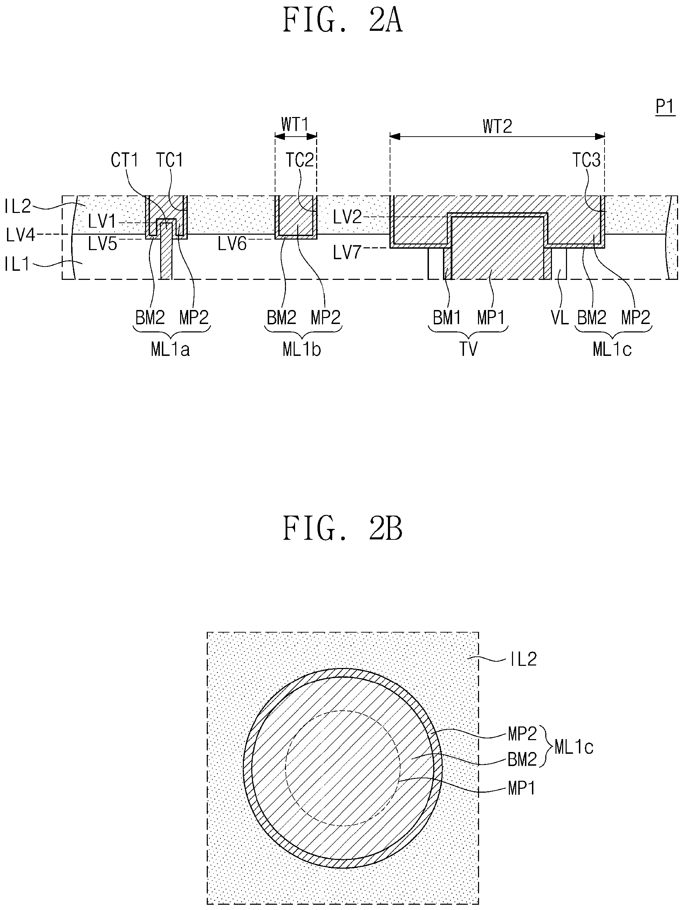

FIG. 1 is a cross-sectional view of a semiconductor device according to embodiments of the inventive concept. FIG. 2A is an enlarged view of portion 'P1' of FIG. 1 according to embodiments of the inventive concept. FIG. 2B is a plan view of a third M1 wiring of FIG. 2A according to embodiments of the inventive concept.

Referring to FIGS. 1, 2A and 2B, a substrate 1 is provided. The substrate 1 may include, for example, a semiconductor material. The substrate 1 may include (e.g., may be formed of), for example, a silicon single crystal substrate (layer). The substrate 1 may include a peripheral circuit region PA and a through via region VA. The substrate 1 includes a first surface 1a and may include a second surface 1b that is opposite to the first surface 1a (in a vertical direction). For example, the first surface 1a of the substrate 1 may be an upper surface of the substrate 1, and the second surface 1b of the substrate 1 may be a lower surface of the substrate 1. A peripheral circuit structure PST may be disposed in the substrate 1 and/or on the first surface 1a of the substrate 1 in the peripheral circuit region PA. The peripheral circuit structure PST may include peripheral transistors and peripheral wirings. A first interlayer insulating layer IL1 is on (e.g., may cover or overlap) the first surface 1a of the substrate 1. A first contact CT1 is disposed in the first interlayer insulating layer IL1 and may be connected (e.g., electrically connected) to the peripheral circuit structure PST. The first interlayer insulating layer IL1 may include (e.g., may be formed of), for example, silicon oxide (e.g., SiO₂). A through via TV is in (e.g., may extend in or penetrate) the first interlayer insulating layer IL1 and the substrate 1. A via insulating layer VL may be in (e.g., may extend in or penetrate) the first interlayer insulating layer IL1 and the substrate 1. For example, the through via TV and the via insulating layer VL may extend in (e.g., penetrate) the first interlayer insulating layer IL1 and the substrate 1 in the vertical direction. The via insulation layer VL may include (e.g., may be formed of), for example, silicon oxide. An air gap region may be disposed in the via insulating layer VL. The via insulating layer VL may extend around (e.g., surround) a sidewall of the through via TV. The through via TV may include a first metal portion MP1 and a first diffusion barrier layer BM1. The first diffusion barrier layer BM1 may be interposed between the first metal portion MP1 and the via insulating layer VL (in a horizontal direction). The first diffusion barrier layer BM1 may have a single-layer or multi-layer structure that includes (e.g., is formed of), for example, titanium, titanium nitride, tantalum, and/or tantalum nitride. The first metal portion MP1 may include (e.g., may be formed of), for example, copper. It will be understood that when an element or layer is referred to as being "connected to", "in contact with", or "coupled to", another element or layer, it may be directly on, connected to, or coupled to the other element or layer, or one or more intervening elements or layers may be present. In contrast, when an element is referred to as being "directly coupled," "directly connected," "in direct contact with", "directly responsive" to, or "directly on," another element, there are no intervening elements present. In addition, "electrical connection" conceptually includes a physical connection and a physical disconnection. As used herein, the term "and/or" includes any and all combinations of one or more of the associated listed items. Expressions such as "at least one of," when preceding a list of elements, modify the entire list of elements and do not modify the individual elements of the list. The horizontal direction may be parallel with the first surface 1a (e.g., the upper surface) of the substrate 1, and the vertical direction may be perpendicular to the first surface 1a (e.g., the upper surface) of the substrate. As used herein, "an element A overlapping an element B in a direction X" (or similar language) means that there is at least one line that extends in the direction X and intersects both the elements A and B.

A second interlayer insulating layer IL2 is disposed on the first interlayer insulating layer IL1. The second interlayer insulating layer IL2 is in direct contact with the first interlayer insulating layer IL1. A density of the second interlayer insulating layer IL2 is less than a density of the first interlayer insulating layer IL1. The second interlayer insulating layer IL2 includes (e.g., may be formed of) a material having a density lower than a density of a material in (of) the first interlayer insulating layer IL1. A mechanical strength of the second interlayer insulating layer IL2 may be lower than a mechanical strength of the first interlayer insulating layer IL1. For example, the material in (of) the second interlayer insulating layer IL2 may have a hardness less than a hardness of the material in (of) the first interlayer insulating layer IL1. The second interlayer insulating layer IL2 may include (e.g., may be formed of) a low-k material having a dielectric constant smaller than that of silicon oxide. In some embodiments, the second interlayer insulating layer IL2 may include carbon, and the first interlayer insulating layer IL1 may exclude carbon. The first interlayer insulating layer IL1 may not include carbon. The second interlayer insulating layer IL2 may include (e.g., may be formed of), for example, a porous insulating material and/or SiOCH.

M1 wirings ML1a, ML1b, and ML1c (which are an example of a first wiring, a third wiring, and a second wiring, respectively) may be disposed in the first interlayer insulating layer IL1 and/or the second interlayer insulating layer IL2. Each of the M1 wirings ML1a, ML1b, and ML1c may include a second metal portion MP2 and a second diffusion barrier layer BM2. The second diffusion barrier layer BM2 may have a single-layer or multi-layer structure that includes (e.g., is formed of), for example, titanium, titanium nitride, tantalum, and/or tantalum nitride. The second metal portion MP2 may include (e.g., may be formed of), for example, copper. The second diffusion barrier layer BM2 may be on (e.g., may cover or overlap) a side surface and a lower surface of the second metal portion MP2.

The M1 wirings ML1a, ML1b, and ML1c may include a first M1 wiring ML1a, a second M1 wiring ML1b, and a third M1 wiring ML1c. The first M1 wiring ML1ais in contact with the first contact CT1. The second M1 wiring ML1b may be spaced apart from the first contact CT1(and/or the through via TV) (in the horizontal direction) without being in contact with the first contact CT1 (and/or the through via TV). The third M1 wiring ML1c is in contact with the through via TV.

Referring to FIG. 2A, each of the first M1 wiring ML1a and the second M1 wiring ML1b may have a first width WT1 (in the horizontal direction). The third M1 wiring ML1c may have a second width WT2 (in the horizontal direction) that is larger than the first width WT1. An upper surface of the first contact CT1 has (is at) a first level LV1. An upper surface of the through via TV (for example an upper surface of the first metal portion MP1 of the through via TV) has (is at) a second level LV2 higher than the first level LV1. An upper surface of the first interlayer insulating layer IL1 has (is at) a fourth level LV4 lower than the first level LV1 and the second level LV2. The first M1 wiring ML1a may be on (e.g., may cover or overlap) the upper surface and upper side surface of the first contact CT1. A lower surface of the first M1 wiring ML1a has (is at) a fifth level LV5 that is lower than the fourth level LV4. A lower surface of the second M1 wiring ML1b may have (may be at) a sixth level LV6. The sixth level LV6 may be equal to (e.g., may be coplanar with) or lower than the fifth level LV5. The third M1 wiring ML1c may be on (e.g., may cover or overlap) the upper surface and upper side surface of the first metal portion MP1 of the through via TV. A lower surface of the third M1 wiring ML1c has (is at) a seventh level LV7 that is lower than the fifth level LV5 and may be lower than the sixth level LV6. The third M1 wiring ML1c may have a pad shape. When viewed in a plan view, the upper surface of the third M1 wiring ML1c may have a circular shape as shown in FIG. 2B. However, the inventive concept is not limited thereto, and the upper surface of the third M1 wiring ML1c may have a square, rectangular, or line shape. As used herein, the term "level" refers to a distance in the vertical direction from the upper surface (the first surface 1a) of the substrate 1. Spatially relative terms, such as "beneath," "below," "lower," "above," "upper," "higher" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly. For example, when element A is referred to be at a higher level than element B, element A may be disposed farther than element B from the upper surface (the first surface 1a) of the substrate 1 in the vertical direction.

In the inventive concept, the second interlayer insulating layer IL2 is in direct contact with the first interlayer insulating layer IL1, and silicon nitride (e.g., Si₃N₄) may not be interposed between the first and second interlayer insulating layers IL1 and IL2, thereby improving adhesion between the second interlayer insulating layer IL2 and the first insulating layer IL1. As a result, reliability of semiconductor devices may be improved.

A dielectric constant of silicon nitride may be higher than that of silicon oxide. When a layer including (e.g., formed of) silicon nitride is interposed between the second interlayer insulating layer IL2 and the first interlayer insulating layer IL1, parasitic capacitance between the M1 wirings ML1a, ML1b, and ML1c may increase and insulation therebetween may decrease, and thus possibility of signal interference between the M1 wirings ML1a, ML1b, and ML1c may increase. However, in the inventive concept, the second interlayer insulating layer IL2 and the first interlayer insulating layer IL1 are in direct contact with each other, and thus signal interference between the M1 wirings ML1a, ML1b, and ML1c may be prevented/minimized/reduced, thereby improving reliability of the semiconductor device.

A second capping layer CPL2 and a third interlayer insulating layer IL3 may be sequentially stacked on the second interlayer insulating layer IL2. The second capping layer CPL2 may include (e.g., may be formed of), for example, SiCN. A dielectric constant of SiCN may be lower than that of silicon nitride (e.g., Si₃N₄). The second capping layer CPL2 may prevent (interrupt) the metal (e.g., copper) in (constituting) the second metal portions MP2 of the M1 wirings ML1a, ML1b, and ML1c from elution/diffusion. The third interlayer insulating layer IL3 may include (e.g., may be formed of) the same material as the second interlayer insulating layer IL2, for example, SiOCH.

M2 wirings ML2 may be in (e.g., may extend in or penetrate) the third interlayer insulating layer IL3 and the second capping layer CPL2 and may be in contact with at least a portion of the M1 wirings ML1a, ML1b, and ML1c, respectively. Each of the M2 wirings ML2 may include a third metal portion MP3 and a third diffusion barrier layer BM3. The M2 wirings ML2 may be formed in a double damascene structure. For example, the third metal portion MP3 may include a via portion VP and a wiring portion LP. The third diffusion barrier layer BM3 may have a single-layer or multi-layer structure that includes (e.g., is formed of), for example, titanium, titanium nitride, tantalum, and/or tantalum nitride. The third metal portion MP3 may include (e.g., may be formed of), for example, copper. The third diffusion barrier layer BM3 may be on (e.g., may cover or overlap) a side surface and a lower surface of the third metal portion MP3. A plurality of M2 wirings ML2 may be disposed on the third M1 wiring ML1c having the relatively wide width WT2.

A third capping layer CPL3 and a fourth interlayer insulating layer IL4 may be sequentially stacked on the third interlayer insulating layer IL3. The third capping layer CPL3 may include (e.g., may be formed of), for example, SiCN. A dielectric constant of SiCN may be lower than that of silicon nitride (e.g., Si₃N₄). The third capping layer CPL3 may prevent (interrupt) the metal (e.g., copper) in (constituting) the third metal portions MP3 of the M2 wirings ML2 from elution/diffusion. The fourth interlayer insulating layer IL4 may include (e.g., may be formed of) the same material as the second interlayer insulating layer IL2, for example, SiOCH.

M3 wirings ML3 may be in (e.g., may extend in or penetrate) the fourth interlayer insulating layer IL4 and the third capping layer CPL3 and may be in contact with some of the M2 wirings ML2, respectively. Each of the M3 wirings ML3 may include a fourth metal portion MP4 and a fourth diffusion barrier layer BM4. The M3 wirings ML3 may be formed in a double damascene structure. For example, the fourth metal portion MP4 may include a via portion VP and a wiring portion LP. The fourth diffusion barrier layer BM4 may have a single-layer or multi-layer structure that includes (e.g., is formed of), for example, titanium, titanium nitride, tantalum, and/or tantalum nitride. The fourth metal portion MP4 may include (e.g., may be formed of), for example, copper. The fourth diffusion barrier layer BM4 may be on (e.g., may cover or overlap) a side surface and a lower surface of the fourth metal portion MP4.

A fourth capping layer CPL4, a fifth interlayer insulating layer IL5, and a sixth interlayer insulating layer IL6 may be sequentially stacked on the fourth interlayer insulating layer IL4. The fourth capping layer CPL4 may include (e.g., may be formed of), for example, SiCN. Each of the fifth interlayer insulating layer IL5 and the sixth interlayer insulating layer IL6 may have a single-layer or multi-layer structure that includes (e.g., is formed of), for example, silicon oxide, silicon nitride, silicon oxynitride, and/or SiCN. The sixth interlayer insulating layer IL6 may also be called a passivation layer, a bonding layer, or an interface layer.

M4 wirings ML4 may be in (e.g., may extend in or penetrate) the fifth interlayer insulating layer IL5 and the fourth capping layer CPL4 and may be in contact with some of the M3 wirings ML3. The M4 wiring ML4 may also be named 'via'. The M4 wiring ML4 may include (e.g., may be formed of), for example, tungsten. A M5 wiring ML5 and an upper bonding pad UBP may be disposed in the sixth interlayer insulating layer IL6. The M5 wiring ML5 may have a pad shape. The M5 wiring ML5 may include (e.g., may be formed of), for example, aluminum. The upper bonding pad UBP may include (e.g., may be formed of), for example, copper.

A passivation layer PL may be on the second surface 1b of the substrate 1. For example, at least a portion of the second surface 1b of the substrate 1 may be covered (overlapped) with a passivation layer PL. The passivation layer PL may have a single-layer or multi-layer structure that includes (e.g., is formed of), for example, SiCN, silicon oxide, and/or silicon nitride. A lower bonding pad LBP may be disposed in the passivation layer PL. The lower bonding pad LBP may include (e.g., may be formed of), for example, copper. The through via TV may be in contact with the lower bonding pad LBP.

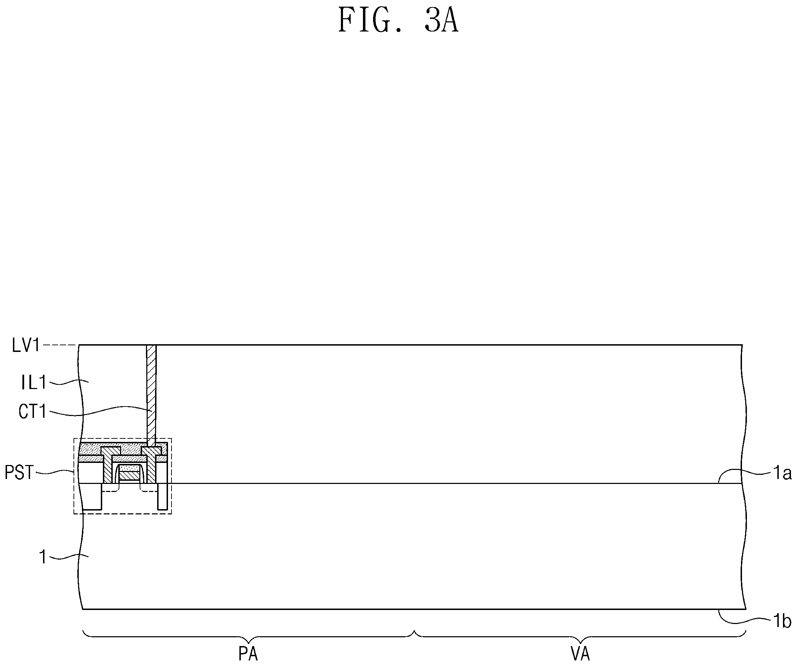

FIGS. 3A to 3M are cross-sectional views sequentially illustrating a method of fabricating the semiconductor device of FIG. 1 according to embodiments of the inventive concept.

Referring to FIG. 3A, a substrate 1 having a first surface 1a and a second surface 1b that are opposite to each other (in the vertical direction) may be prepared. The substrate 1 may include a peripheral circuit region PA and a through via region VA. A peripheral circuit structure PST may be formed in the substrate 1 and/or on the first surface 1a of the substrate 1 in the peripheral circuit region PA. A first interlayer insulating layer IL1 is formed on (e.g., may cover or overlap) the first surface 1a of the substrate 1. A contact hole may be formed in the first interlayer insulating layer IL1 and filled with a conductive layer, and then a full-surface anisotropic etching process and/or a polishing process may be performed to form a first contact CT1. Accordingly, an upper surface of the first interlayer insulating layer IL1 and an upper surface of the first contact CT1 may have (may be at) a first level LV1.

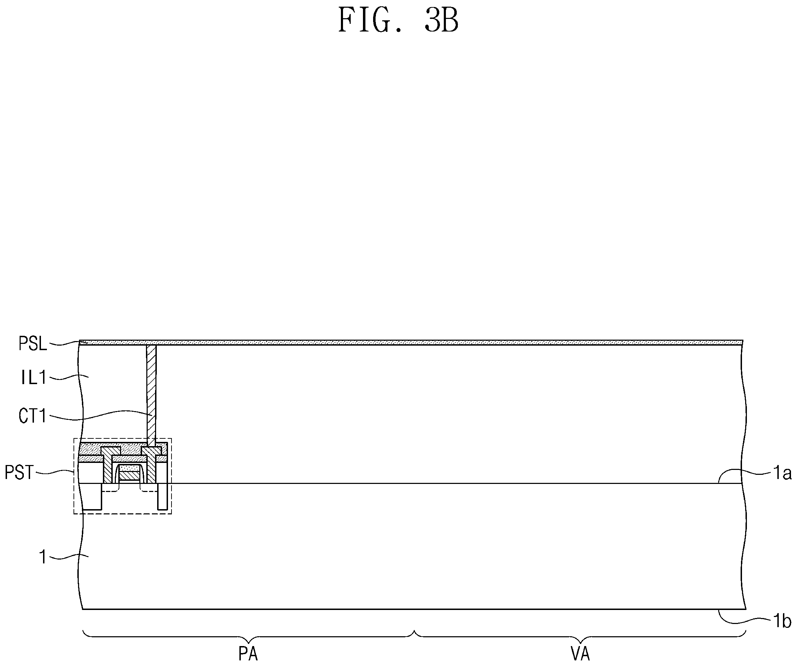

Referring to FIG. 3B, a polishing stop layer PSL is formed on (the upper surface of) the first interlayer insulating layer IL1 and (the upper surface of) the first contact CT1. The polishing stop layer PSL may include (e.g., may be formed of), for example, silicon nitride.

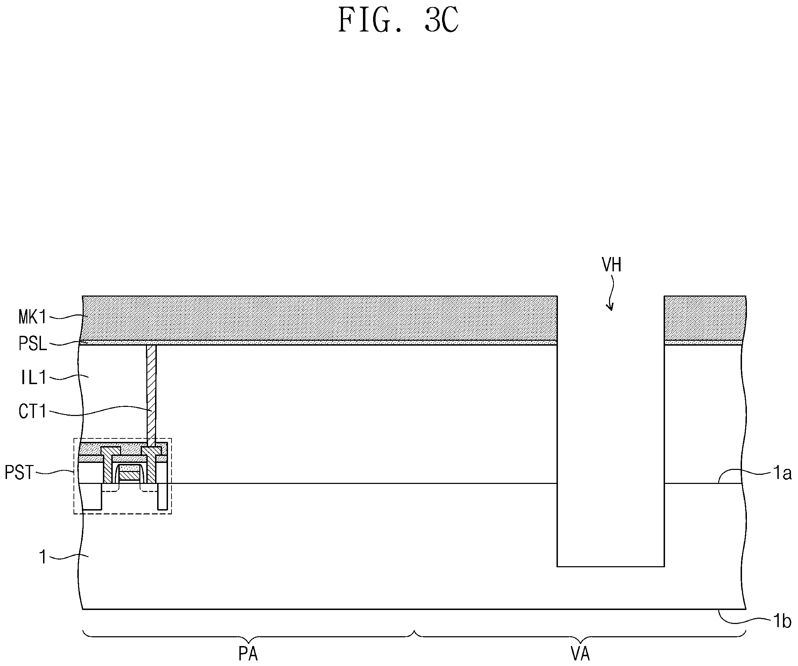

Referring to FIG. 3C, a first mask pattern MK1 may be formed on the polishing stop layer PSL. The first mask pattern MK1 may include (e.g., may be formed as), for example, a photoresist pattern. The first mask pattern MK1 may define a position in a through via region VA where a through via TV and a via insulating layer VL will be formed. A portion of the polishing stop layer PSL, a portion of the first interlayer insulating layer IL1, and a portion of the substrate 1 are removed by etching (for example using the first mask pattern MK1 as an etch mask) to form a through via hole VH. In some embodiments, the through via hole VH may extend in (e.g., penetrate through) the polishing stop layer PSL and the first interlayer insulating layer IL1. The through via hole VH may extend in at least a portion of the substrate 1.

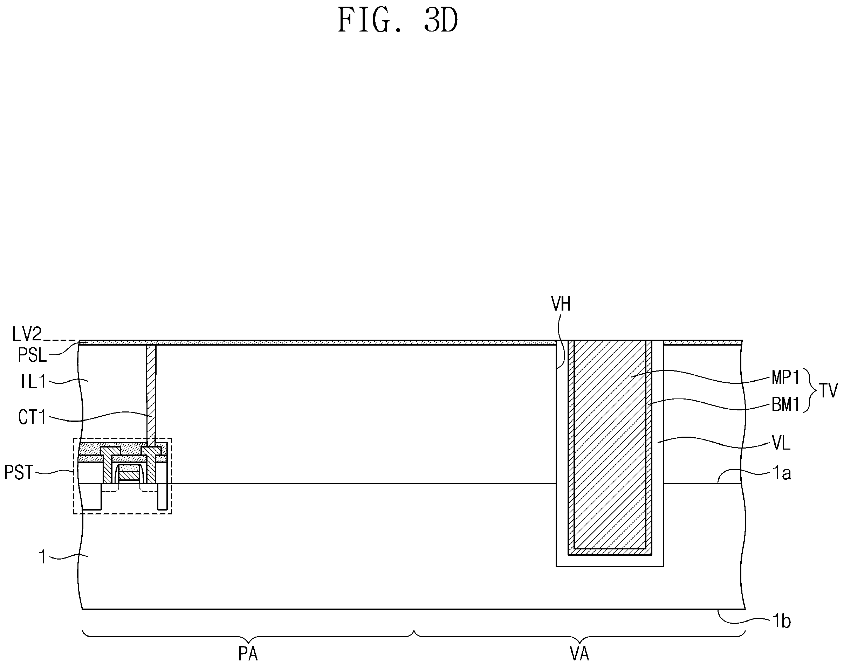

Referring to FIG. 3D, the first mask pattern MK1 may be removed. A via insulating layer VL, a first diffusion barrier layer BM1, and a first metal layer (which will become a first metal portion MP1 after the following processes (e.g., a CMP process)) may be sequentially stacked on the polishing stop layer PSL to fill the through via hole VH, and then a chemical mechanical polishing (CMP) process may be performed. A via insulating layer VL and a through via TV are formed in the through via hole VH while an upper surface of the polishing stop layer PSL may be exposed. After the polishing process (e.g., the CMP process), the upper surface of the polishing stop layer PSL and an upper surface of the through via TV (e.g., an upper surface of the first metal portion MP1) may have (may be at) a second level LV2 that is higher than the first level LV1.

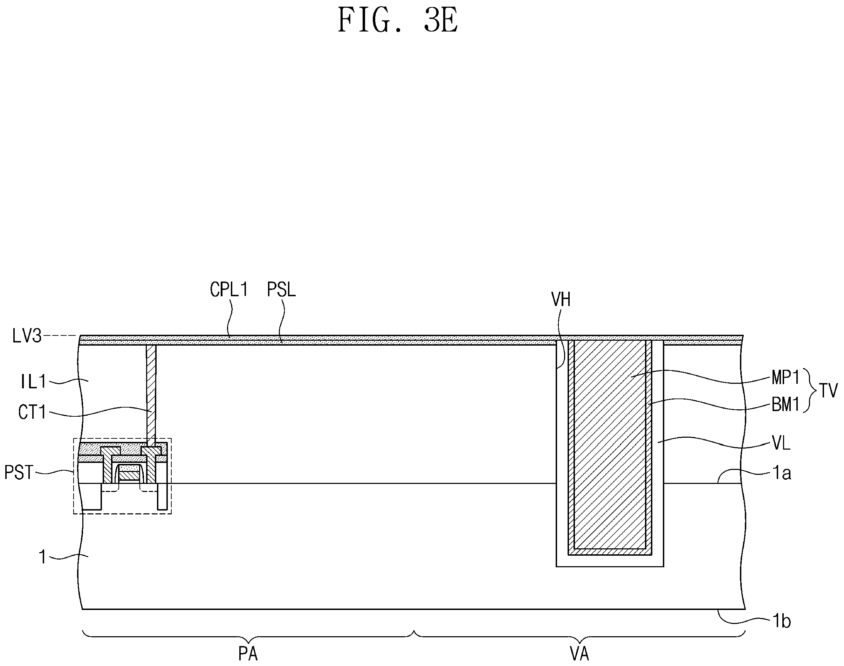

Referring to FIG. 3E, a first capping layer CPL1 is formed on (e.g., may cover or overlap) the polishing stop layer PSL and the through via TV. The first capping layer CPL1 may include (e.g., may be formed of), for example, silicon nitride and/or SiCN. The first capping layer CPL1 may prevent (interrupt) elution/diffusion of metal (e.g., copper) in (constituting) the first metal portion MP1 of the through via TV. An upper surface of the first capping layer CPL1 may have (may be at) a third level LV3 that is higher than the second level LV2.

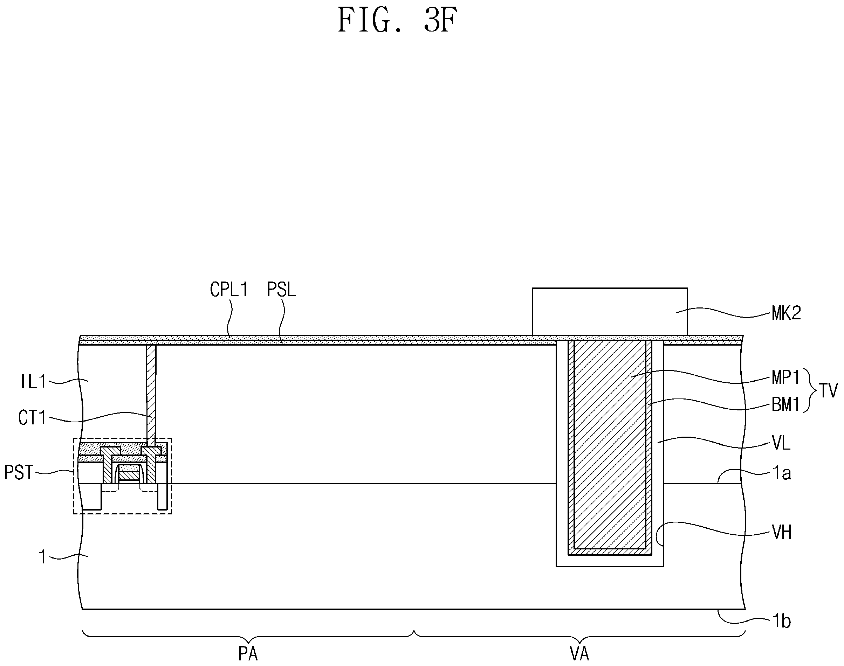

Referring to FIG. 3F, a second mask pattern MK2 is formed on the first capping layer CPL1. The second mask pattern MK2 may include (e.g., may be formed as) a photoresist pattern. The second mask pattern MK2 overlaps at least a portion of the through via TV and a portion of the first capping layer CPL1 adjacent the through via TV.

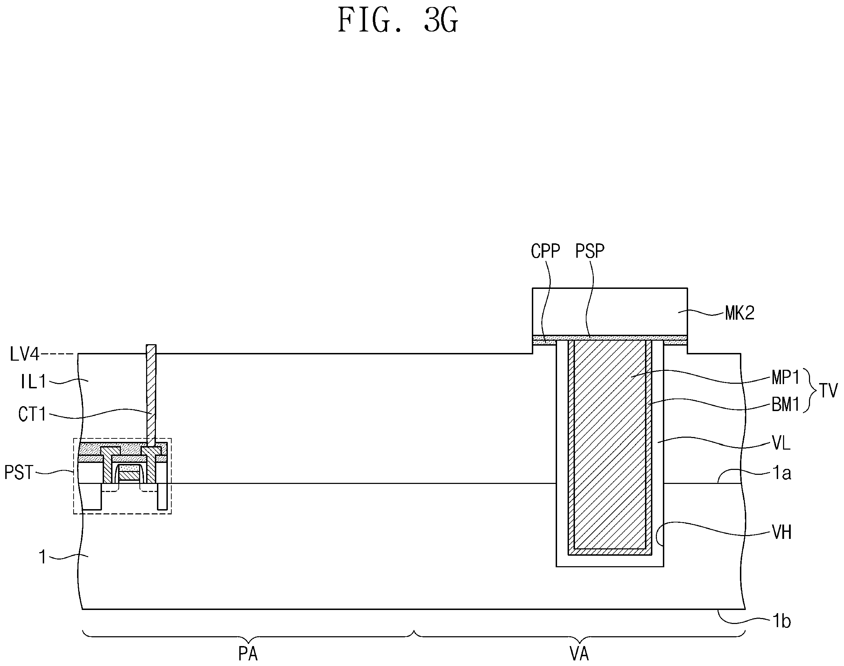

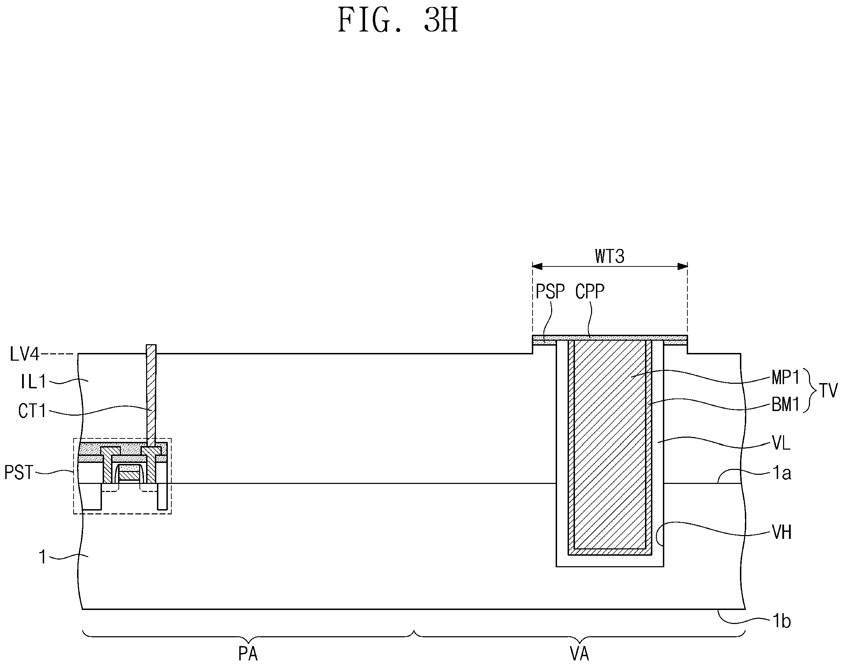

Referring to FIGS. 3G and 3H, the first capping layer CPL1 and the polishing stop layer PSL that are exposed from and adjacent to the second mask pattern MK2 are removed (may be (sequentially) etched using the second mask pattern MK2 as an etch mask) to expose an upper surface of the first interlayer insulating layer IL1, and to form a capping pattern CPP and a polishing stop pattern PSP, respectively. For example, portions of the first capping layer CPL1 and the polishing stop layer PSL that are not covered (not overlapped) by the second mask pattern MK2 are removed (e.g., etched) to expose a portion of the upper surface of the first interlayer insulating layer IL1 and to form the capping pattern CPP and the polishing stop pattern PSP, respectively. The polishing stop pattern PSP may be formed as a portion of the polishing stop layer PSL. The capping pattern CPP may be formed as a portion of the first capping layer CPL1. Sidewalls of the polishing stop pattern PSP and the capping pattern CPP may be formed to be aligned with each other. The capping pattern CPP may be formed to have a third width WT3 (in the horizontal direction) as shown in FIG. 3H. In the etching process, a portion of the first interlayer insulating layer IL1 may also be etched, such that the upper surface of the first interlayer insulating layer IL1 is lowered (from the first level LV1) to a fourth level LV4. Accordingly, an upper surface and a portion of sidewall (e.g., an upper sidewall) of the first contact CT1 may be exposed.

Referring to FIG. 3H, the second mask pattern MK2 is removed to expose an upper surface of the capping pattern CPP.

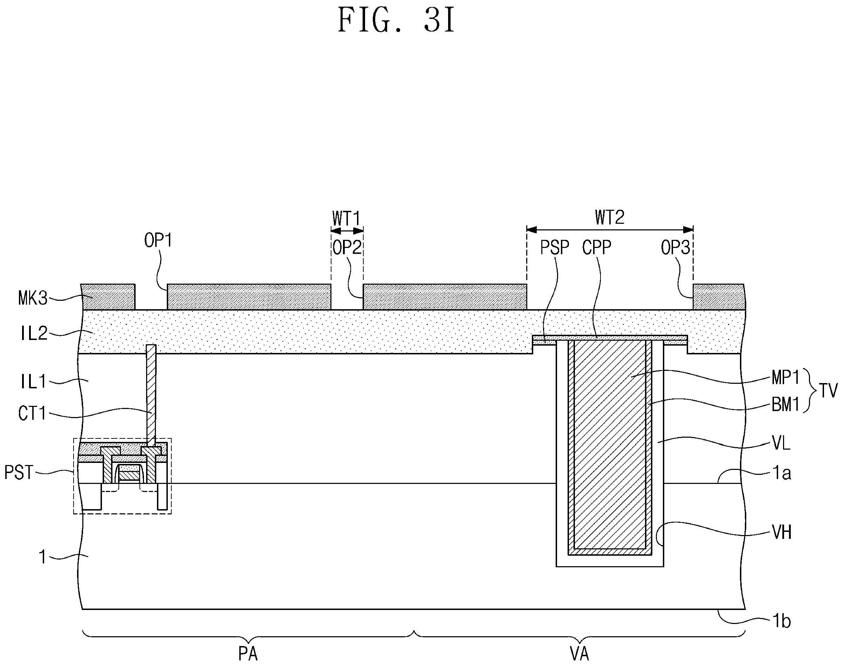

Referring to FIG. 3I, a second interlayer insulating layer IL2 is formed on the first interlayer insulating layer IL1. In addition, a third mask pattern MK3 may be formed on the second interlayer insulating layer IL2. The third mask pattern MK3 may include first, second, and third openings OP1, OP2, and OP3 respectively defining positions of M1 wirings ML1a, ML1b, and ML1c of FIG. 1. The first and second openings OP1 and OP2 may be formed to have a first width WT1 (in the horizontal direction). The third opening OP3 may be formed to have a second width WT2 (in the horizontal direction). The second width WT2 may be greater (wider) than the third width WT3 of the capping pattern CPP in FIG. 3H.

In the inventive concept, the second interlayer insulating layer IL2 is formed to be in direct contact with the first interlayer insulating layer IL1, thereby improving adhesion between the second interlayer insulating layer IL2 and the first interlayer insulating layer IL1. As a result, process defects may be prevented (reduced), and yield may be increased.

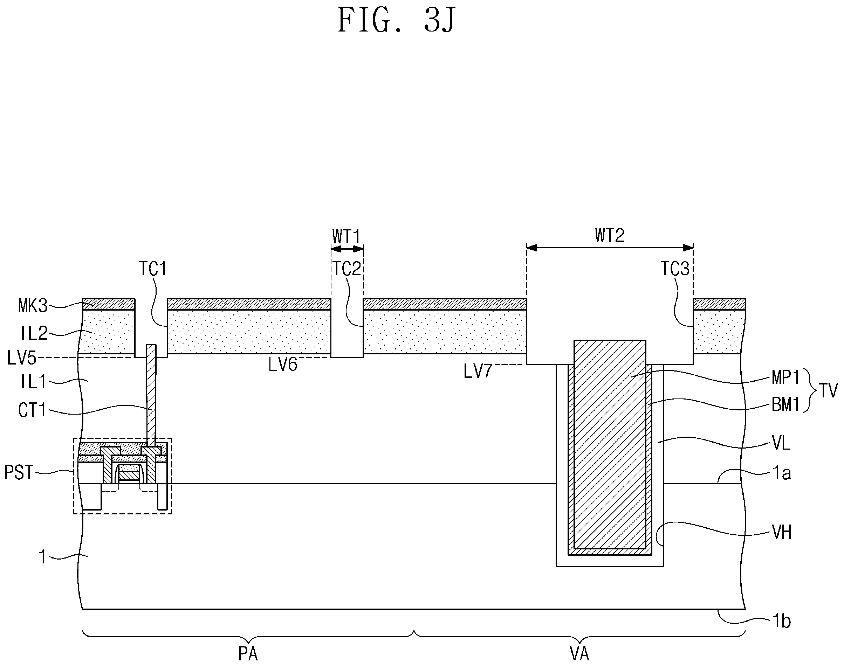

Referring to FIG. 3J, the second interlayer insulating layer IL2 may be etched using the third mask pattern MK3 as an etch mask to form first, second, and third trenches TC1, TC2, and TC3. In the etching process, a portion of an upper portion of the first interlayer insulating layer IL1 may also be removed. Additionally, a portion (e.g., an upper portion) of the via insulating layer VL and a portion (e.g., an upper portion) of the first diffusion barrier layer BM1 may also be removed. The first and second trenches TC1 and TC2 may be formed to have a first width WT1 (in the horizontal direction). The third trench TC3 may be formed to have a second width WT2 (in the horizontal direction). Due to the loading effect, as a width of the trench (in the horizontal direction) is greater (wider), a depth of the trench (in the vertical direction) may be greater (deeper). A lower surface of the first trench TC1 has (is at) a fifth level LV5. A lower surface of the second trench TC2 may have (may be at) a sixth level LV6. A lower surface of the third trench TC3 has (is at) a seventh level LV7. The fifth level LV5 may be equal to or higher than the sixth level LV6. This is because it may be difficult for an etchant to approach the lower surface of the first trench TC1 due to influence of the first contact CT1 on (e.g., protruding from) the lower surface of the first trench TC1. The seventh level LV7 is lower than the fifth level LV5 and may be lower than the sixth level LV6.

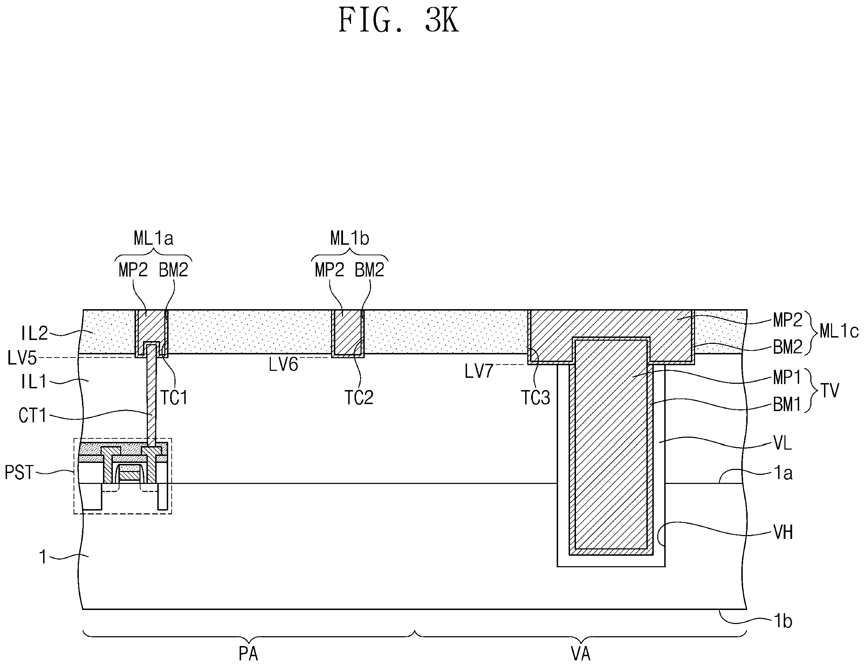

Referring to FIG. 3K, the third mask pattern MK3 may be removed. Then, a second diffusion barrier layer BM2 and a second metal layer (which will become a second metal portion MP2 after the following processes (e.g., CMP process)) may be sequentially and conformally stacked on the entire surface of the second interlayer insulating layer IL2 to fill the first, second, and third trenches TC1, TC2, and TC3, and a polishing process (e.g., a CMP process) may be performed. As a result, an upper surface of the second interlayer insulating layer IL2 may be exposed while first, second, and third M1 wirings ML1a, ML1b, and ML1c are formed in the first, second, and third trenches TC1, TC2, and TC3.

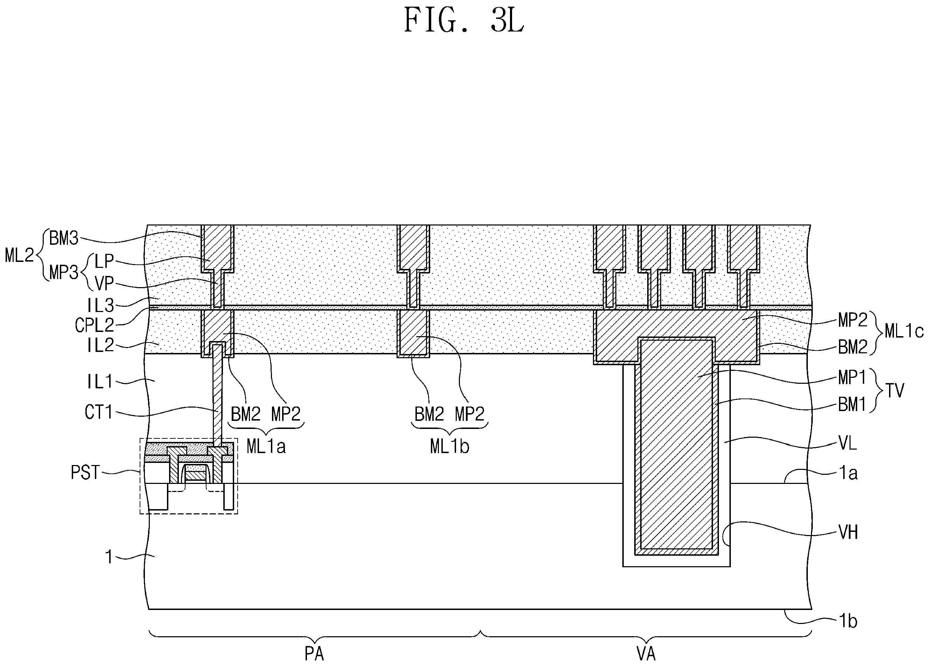

Referring to FIG. 3L, a second capping layer CPL2 and a third interlayer insulating layer IL3 may be sequentially stacked on the second interlayer insulating layer IL2. Double damascene holes may be formed in the third interlayer insulating layer IL3 and the second capping layer CPL2. A third diffusion barrier layer BM3 and a third metal layer (which will become a third metal portion MP3 after the following processes (e.g., CMP process)) may be sequentially and conformally stacked on the third interlayer insulating layer IL3 to fill the double damascene holes, and a polishing process (e.g., CMP process) may be performed to form M2 wirings ML2.

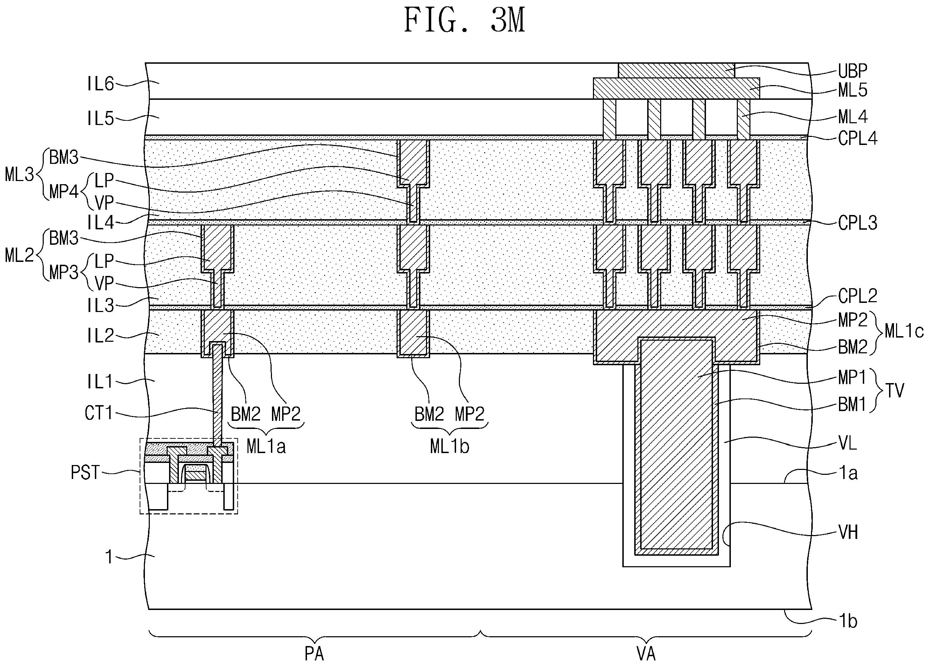

Referring to FIG. 3M, a third capping layer CPL3, a fourth interlayer insulating layer IL4, M3 wirings ML3, a fourth capping layer CPL4, a fifth interlayer insulating layer IL5, M4 wirings ML4, a sixth interlayer insulating layer IL6, a M5 wiring ML5, and an upper bonding pad UBP may be formed on the third interlayer insulating layer IL3 in the same/similar manner as described in FIG. 3L. Then, referring to FIG. 1, a back-grinding process may be performed on the second surface 1b of the substrate 1 to expose (a portion of) the through via TV. A passivation layer PL and a lower bonding pad LBP may be formed on the second surface 1b of the substrate 1. Accordingly, the semiconductor device of FIG. 1 may be fabricated.

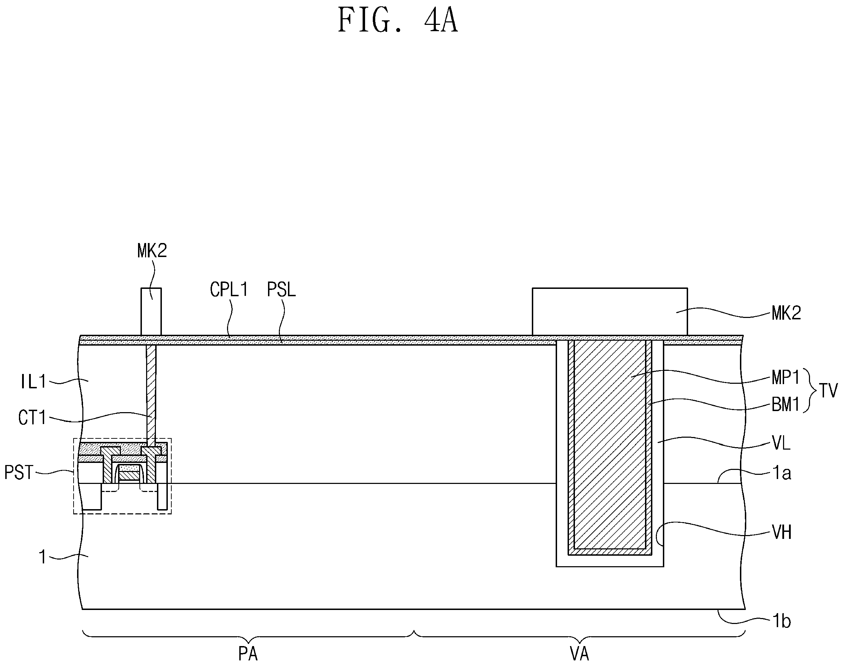

FIGS. 4A to 4D are cross-sectional views sequentially illustrating a method of fabricating the semiconductor device of FIG. 1 according to embodiments of the inventive concept. The processes of FIGS. 4A to 4D may correspond to the processes of FIGS. 3F to 3I, respectively. The same reference numerals as in FIGS. 3F to 3I respectively denote the same members unless clearly stated otherwise, and here, repeated descriptions thereof may be omitted.

Referring to FIG. 4A, the second mask pattern MK2 may be formed in the plural to be on (e.g., to cover or overlap) not only the through via TV but also the first contact CT1.

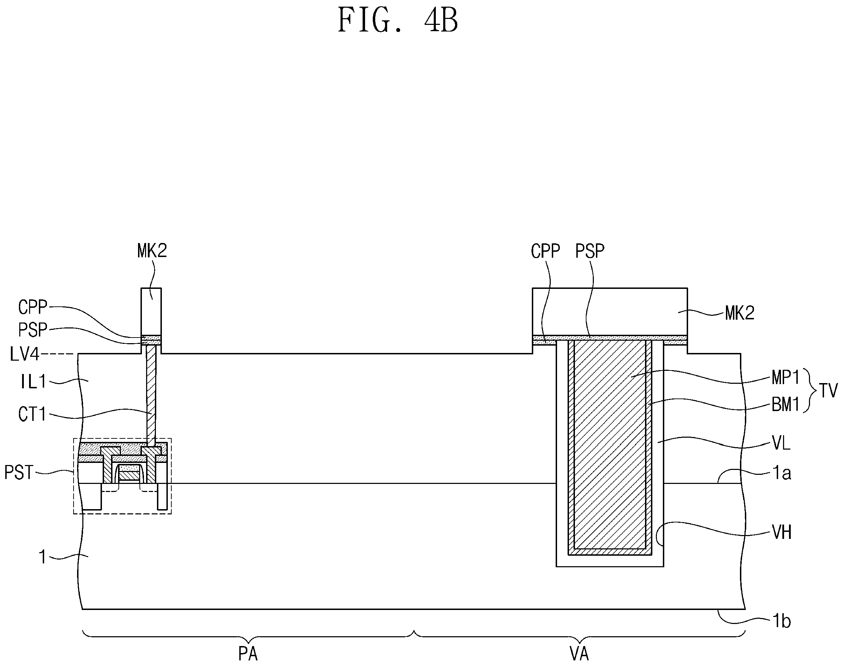

Referring to FIG. 4B, the first capping layer CPL1 and the polishing stop layer PSL that are exposed from and adjacent to the second mask pattern MK2 are (sequentially) removed using the second mask patterns MK2 as an etch mask, to expose portions of an upper surface of the first interlayer insulating layer IL1 and to form capping patterns CPP and polishing stop patterns PSP, respectively. One of the capping patterns CPP may be on (e.g., may cover or overlap) the through via TV, and the other of the capping patterns CPP may be on (e.g., may cover or overlap) the first contact CT1. In the etching process, a portion of the first interlayer insulating layer IL1 may also be etched, such that the upper surface of the first interlayer insulating layer IL1 is lowered (from the first level LV1) to the fourth level LV4. The upper sidewall of the first contact CT1 may be covered (or overlapped) with a portion of the first interlayer insulating layer IL1. The capping patterns CPP may protect the through via TV and the first contact CT1 during the (following) etching processes.

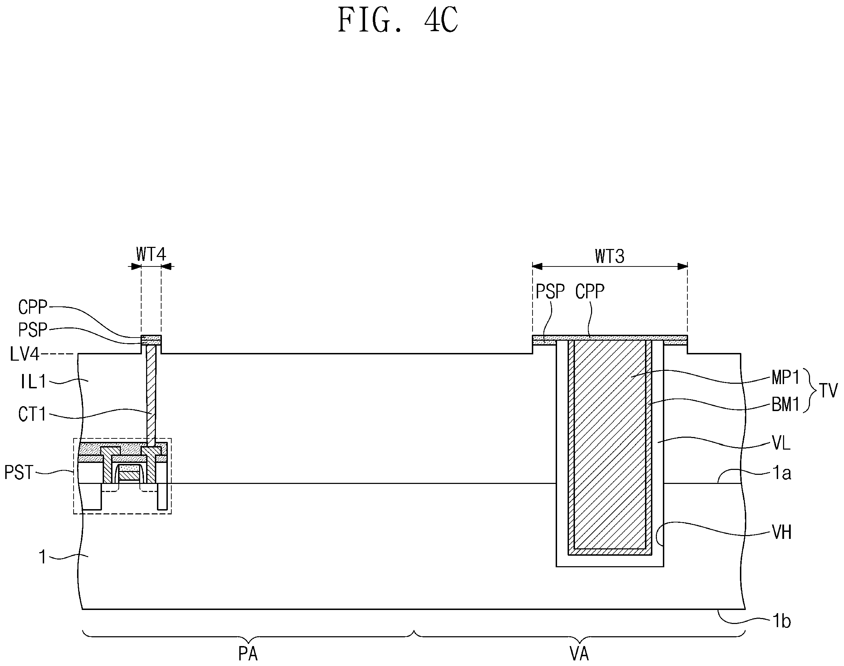

Referring to FIGS. 4B and 4C, the capping pattern CPP may have a third width WT3 (in the horizontal direction) on the through via TV. On the first contact CT1, the capping pattern CPP and the polishing stop pattern PSP may each have a fourth width WT4 (in the horizontal direction). The second mask pattern MK2 may be removed to expose an upper surface of the capping patterns CPP.

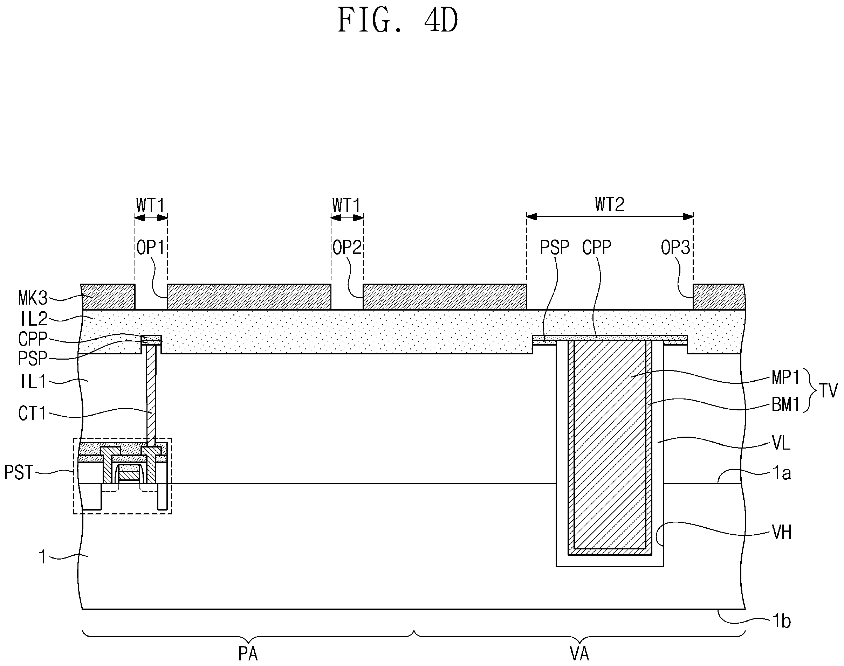

Referring to FIG. 4D, a second interlayer insulating layer IL2 may be formed on the first interlayer insulating layer IL1. Then, a third mask pattern MK3 may be formed on the second interlayer insulating layer IL2. The third mask pattern MK3 may include first, second, and third openings OP1, OP2, and OP3 respectively defining positions of the M1 wirings ML1a, ML1b, and ML1c of FIG. 1. The first and second openings OP1 and OP2 may be formed to have a first width WT1 (in the horizontal direction). The first width WT1 may be greater (wider) than the fourth width WT4 (in FIG. 4C). The third opening OP3 may be formed to have a second width WT2 (in the horizontal direction). The second width WT2 may be greater (wider) than the third width WT3 of the capping pattern CPP in FIG. 3H (or in FIG. 4C).

Referring to FIGS. 4D and 3J, the second interlayer insulating layer IL2 may be etched using the third mask pattern MK3 as an etch mask, to form first, second, and third trenches TC1, TC2, and TC3. In this case, both the polishing stop patterns PSP and the capping patterns CPP may be removed. Subsequently, the processes described with reference to FIGS. 3K to 3M may be performed.

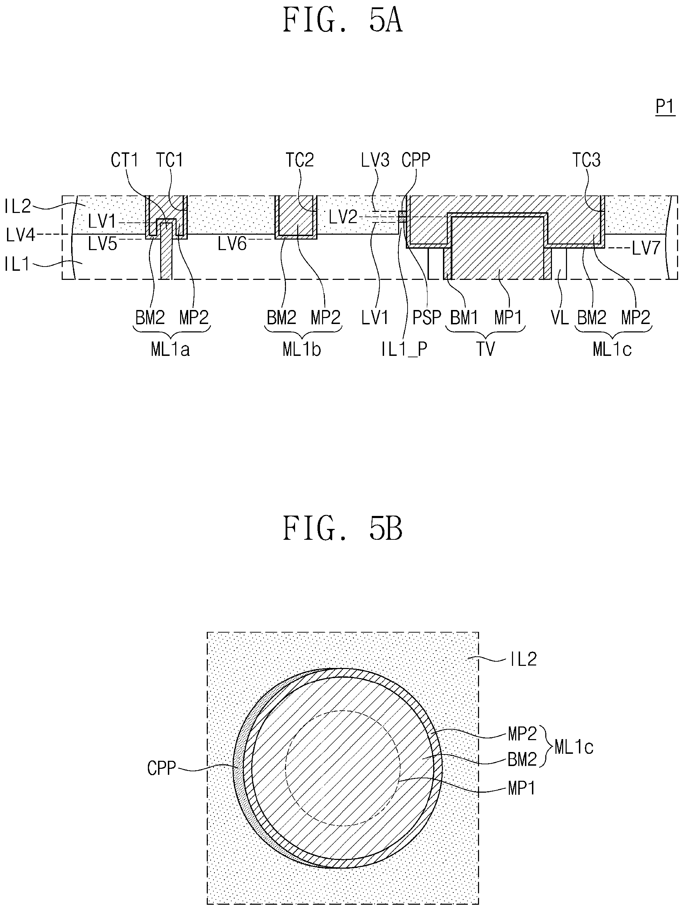

FIG. 5A is an enlarged view corresponding to portion 'P1' of FIG. 1 according to embodiments of the inventive concept. FIG. 5B is a plan view of a third M1 wiring (ML1c) of FIG. 5A.

Referring to FIGS. 5A and 5B, a polishing stop pattern PSP and a capping pattern CPP may be disposed on (e.g., may be in contact with) one side (a side surface) of third M1 wiring ML1c. A first interlayer insulating layer IL1 may include a protrusion IL1_P that is on (in contact with) one side (a side surface) of the third M1 wiring ML1c. For example, an upper surface of the first interlayer insulating layer IL1 may have the protrusion IL1_P that extends away from the upper surface (e.g., the first surface 1a) of the substrate 1. For example, the first interlayer insulating layer IL1 may have upper surfaces at different distances from the upper surface (e.g., the first surface 1a) of the substrate 1. In some embodiments, an upper surface of the protrusion IL1_P may be the uppermost surface of the first interlayer insulating layer IL1. For example, the upper surface of the protrusion IL1_P may be the farthest upper surface of the first interlayer insulating layer IL1 from the upper surface (e.g., the first surface 1a) of the substrate 1. The polishing stop pattern PSP and the capping pattern CPP may be sequentially stacked on the protrusion IL1_P. Side surfaces of the polishing stop pattern PSP, capping pattern CPP, and protrusion IL1_P may be aligned with each other and may be in contact with the second interlayer insulating layer IL2. The polishing stop pattern PSP and the capping pattern CPP may be spaced apart from first and second M1 wirings ML1a and ML1b by a second interlayer insulating layer IL2.

An upper surface of the protrusion IL1_P may have (may be at) the first level LV1. An upper surface of the polishing stop pattern PSP may have (may be at) the second level LV2 that is higher than the first level LV1. An upper surface of the capping pattern CPP may have the third level LV3 that is higher than the second level LV2. The polishing stop pattern PSP and the capping pattern CPP may include the same material, for example, silicon nitride. Alternatively, the polishing stop pattern PSP and the capping pattern CPP may include different materials. At this case, the polishing stop pattern PSP may include (e.g., may be formed of), for example, silicon nitride, and the capping pattern CPP may include (e.g., may be formed of), for example, SiCN. According to one example, the polishing stop pattern PSP and the capping pattern CPP may have (may be) a 'C' shape or 'C'-like (crescent moon) shape as shown in FIG. 5B when viewed in a plan view. Other structures may be the same/similar to those described with reference to FIGS. 1 and 2A.

The semiconductor devices of FIGS. 5A and 5B may be formed when a position of the third mask pattern MK3 of FIG. 3I is (partially) misaligned. As a result, the polishing stop pattern PSP and the capping pattern CPP in FIG. 3I may not be all removed as illustrated in FIG. 3J and some portions of the polishing stop pattern PSP and the capping pattern CPP may remain, thereby forming the semiconductor devices of FIGS. 5A and 5B. Other fabricating processes may be the same/similar to those described above.

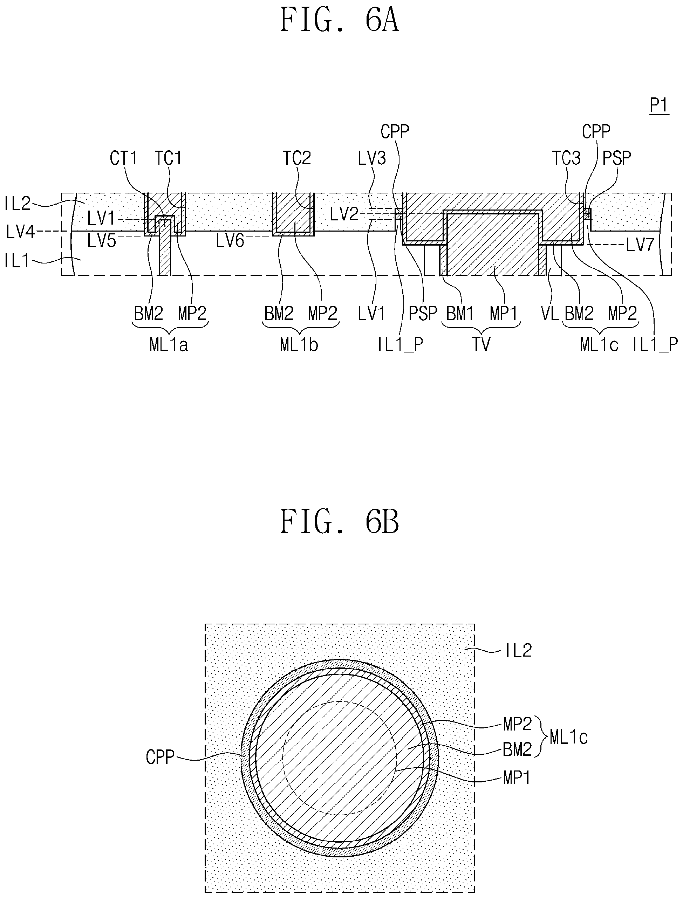

FIG. 6A is an enlarged view corresponding to portion 'P1' of FIG. 1 according to embodiments of the inventive concept. FIG. 6B is a plan view of a third M1 wiring (ML1c) of FIG. 6A.

Referring to FIGS. 6A and 6B, a polishing stop pattern PSP and a capping pattern CPP may be disposed on (e.g., may be in contact with) both (e.g., opposite) sides (e.g., side surfaces) of a third M1 wiring ML1c. A first interlayer insulating layer IL1 may include protrusions IL1_P that are on (e.g., in contact with) the both (e.g., the opposite) sides (e.g., side surfaces) of the third M1 wiring ML1c. When viewed in a plan view, the polishing stop pattern PSP and the capping pattern CPP may have a ring shape or a closed curve shape extending around (e.g., surrounding) the third M1 wiring ML1c. Other structures may be the same/similar to those described with reference to FIGS. 5A and 5B.

The semiconductor device of FIGS. 6A and 6B may be formed when the second width WT2 of the third opening OP3 of the third mask pattern MK3 of FIG. 3I is smaller than the third width WT3 of the capping pattern CPP of FIG. 3H. Other fabricating processes may be the same/similar to those described above.

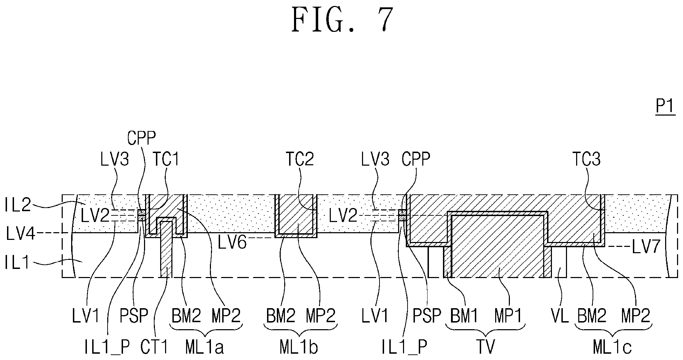

FIG. 7 is an enlarged view corresponding to portion 'P1' of FIG. 1 according to embodiments of the inventive concept.

Referring to FIG. 7, a plurality of polishing stop patterns PSP and a plurality of capping patterns CPP may be provided. The polishing stop pattern PSP and the capping pattern CPP may be disposed on (e.g., may be in contact with) one side (e.g., a side surface) of the first M1 wiring ML1a. The polishing stop pattern PSP and the capping pattern CPP may be disposed on (e.g., may be in contact with) one side (e.g., a side surface) of the third M1 wiring ML1c. A first interlayer insulating layer IL1 may include protrusions IL1_P that are in contact with side surfaces of the first M1 wiring ML1a and the third M1 wiring ML1c. The polishing stop pattern PSP and the capping pattern CPP may be spaced apart from the second M1 wiring ML1b. The polishing stop pattern PSP and the capping pattern CPP may be on each of the protrusions IL1_P. Other structures may be the same/similar to those described with reference to FIGS. 5A and 5B.

The semiconductor device of FIG. 7 may be formed when a position of the third mask pattern MK3 of FIG. 4D is (partially) misaligned. In some embodiments, the semiconductor device of FIG. 7 may be formed when the first width WT1 of the first opening OP1 in FIG. 4D is smaller than the fourth width WT4 of the capping pattern CPP on the first contact CT1 in FIG. 4C and/or the second width WT2 of the third opening OP3 of the third mask pattern MK3 of FIG. 3I is smaller than the third width WT3 of the capping pattern CPP of FIG. 3H. Other fabricating processes may be the same/similar to those described above.

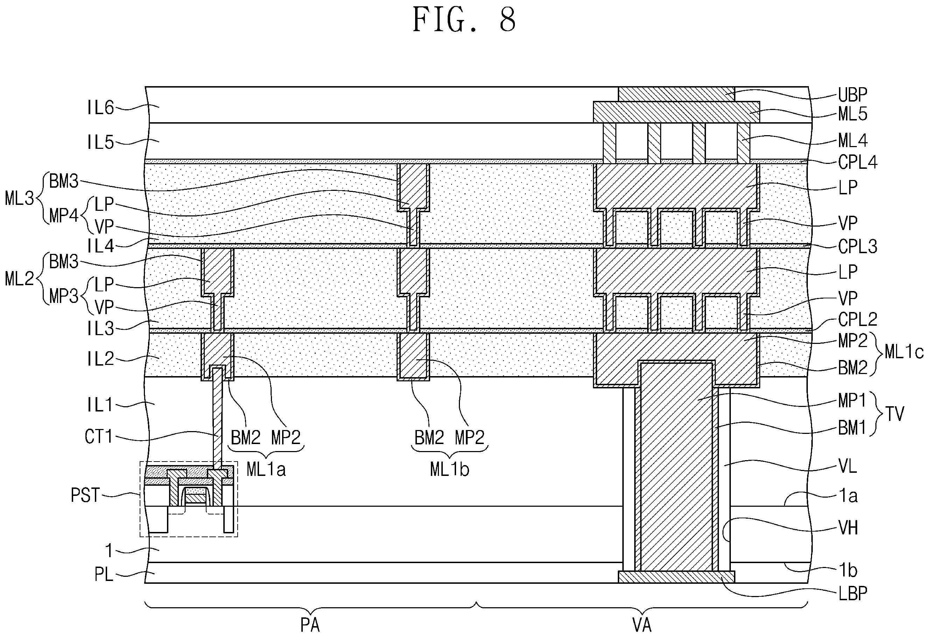

FIG. 8 is a cross-sectional view of a semiconductor device according to embodiments of the inventive concept.

Referring to FIG. 8, in the semiconductor device according to the present example, wiring portions LP of the M2 wirings ML2 disposed on (e.g., overlapped in the vertical direction) the third M1 wiring ML1c may be connected to each other. For example, the wiring portions LP of the M2 wirings ML2 overlapped with the third M1 wiring ML1c in the vertical direction may be connected to each other to form an integrated structure without a visible boundary therebetween. Additionally, the wiring portions LP of the M3 wirings ML3 disposed on (e.g., overlapped in the vertical direction) the third M1 wiring ML1c may be connected to each other. For example, the wiring portions LP of the M3 wirings ML3 overlapped with the third M1 wiring ML1c in the vertical direction may be connected to each other to form an integrated structure without a visible boundary therebetween. Other structures may be the same/similar to those described above.

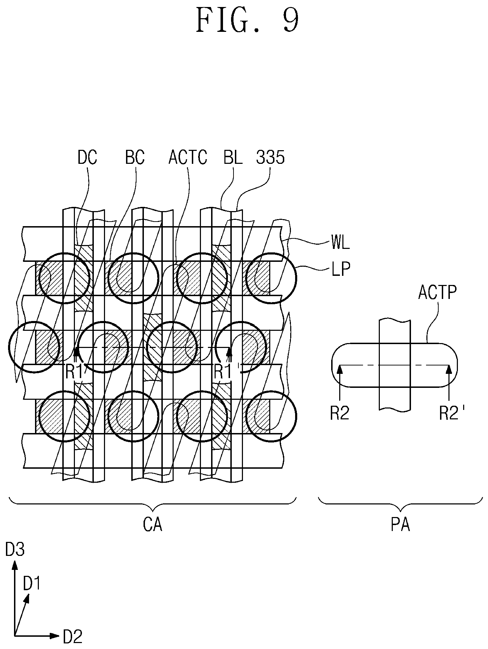

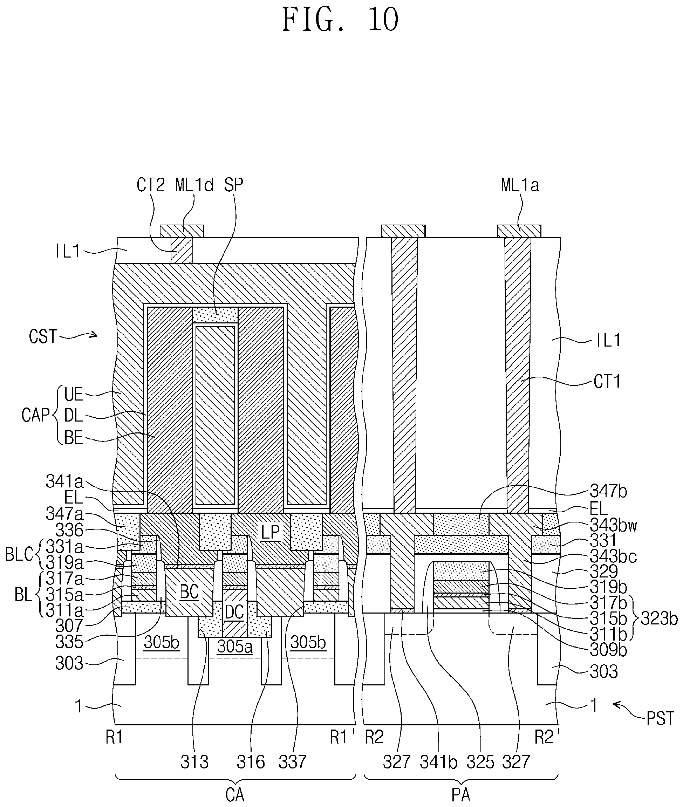

FIG. 9 is a plan view of a semiconductor device according to embodiments of the inventive concept. FIG. 10 are cross-sectional views taken along lines R1-R1' and R2-R2' of FIG. 9 according to embodiments of the inventive concept.

Referring to FIGS. 9 and 10, a substrate 1 may include a cell array region CA and a peripheral circuit region PA. Although not shown in FIGS. 9 and 10, the substrate 1 may further include the through via region VA of FIG. 1. The structures described with reference to FIGS. 1 to 8 may be disposed on (in) the through via region VA. A cell structure CST may be disposed on (in) the cell array region CA and a peripheral circuit structure PST may be disposed on (in) the peripheral circuit region PA. A first interlayer insulating layer IL1 may be on (e.g., may cover or overlap) the cell structure CST and the peripheral circuit structure PST.

A device isolation layer 303 may be disposed on (in) the substrate 1 to define cell active portions ACTC and peripheral active portions ACTP. Each of the cell active portions ACTC may have an isolated shape. Each of the cell active portions ACTC may have a bar shape elongated in a first direction D1 when viewed in a plan view. The substrate 1 may include (e.g., may be) a silicon single crystal substrate or an SOI substrate. The device isolation layer 303 may include, for example, an oxide liner, a nitride liner, and/or a buried insulating layer. The cell active portions ACTC may be arranged to be parallel to each other in the first direction D1, and an end (portion) of one cell active portion ACTC (in a third direction D3) may be arranged adjacent to a center (portion) of another cell active portion ACTC (in the third direction D3) adjacent thereto.

Word lines WL may cross (overlap) the cell active portions ACTC. The word lines WL may be disposed in grooves formed in the device isolation layer 303 and the cell active portions ACTC. The word lines WL may be parallel to a second direction D2 (may extend in a second direction D2) that intersects the first direction D1. At least a portion of the word lines WL may be (recessed) in the substrate 1.

A first impurity region 305a may be disposed in each cell active region ACTC between a pair of (adjacent) word lines WL, and a pair of second impurity regions 305b may be disposed in both (e.g., opposite) edge regions of each cell active region ACTC. For example, the first and second impurity regions 305a and 305b may be doped with N-type impurities. The first impurity region 305a may correspond to a common drain region, and the second impurity regions 305b may correspond to a source region.

A first insulating layer 307 may be disposed on the substrate 1 in the cell array region CA. The first insulating layer 307 may include a single layer or multiple layer structure that includes (e.g., is formed of), for example, a silicon oxide layer, a silicon nitride layer, and/or a silicon oxynitride layer.

Bit lines BL may be disposed on the first insulating layer 307. The bit lines BL may cross (overlap) the word lines WL. As shown in FIG. 9, the bit lines BL may be parallel to the third direction D3 (may extend in the third direction D3) that intersects the first and second directions D1 and D2. The bit lines BL may include a cell polysilicon pattern 311a, a cell ohmic pattern 315a, and a cell metal-containing pattern 317a that are sequentially stacked. The cell polysilicon pattern 311a may include, for example, polysilicon doped with impurities. The cell ohmic pattern 315a may include (e.g., may be formed of), for example, a metal silicide such as cobalt silicide. The cell metal-containing pattern 317a may include, for example, a metal such as aluminum, tungsten, and/or copper. A bit line capping pattern BLC may be disposed on the bit line BL. The bit line capping pattern BLC may include a first bit line capping pattern 319a and a second bit line capping pattern 331a that are sequentially stacked. The first bit line capping pattern 319a and the second bit line capping pattern 331a may include (e.g., may be formed of), for example, a silicon nitride layer.

A first bit line spacer 335 may be on a sidewall of the bit line BL and a lower sidewall of the bit line capping pattern BLC. For example, the sidewall of the bit line BL and the lower sidewall of the bit line capping pattern BLC may be covered (overlapped) with the first bit line spacer 335. A second bit line spacer 336 may be on an upper sidewall of the bit line capping pattern BLC. For example, the upper sidewall of the bit line capping pattern BLC may be covered (overlapped) with the second bit line spacer 336. The first and second bit line spacers 335 and 336 may each have a single-layer or multi-layer structure that includes (e.g., is formed of), for example, a silicon nitride layer, a silicon oxide layer, and/or a silicon oxynitride layer. The second bit line spacer 336 may include an air gap therein.

The first insulating layer 307 may be interposed between the bit line BL and the substrate 1 and between the first bit line spacer 335 and the substrate 1. A sidewall of the first bit line spacer 335 may be aligned with a sidewall of the first insulating layer 307.

The bit line BL may be electrically connected to the first impurity region 305a through a bit line contact DC. The bit line contact DC may include (e.g., may be formed of), for example, polysilicon doped with impurities. A recess region 313 may be formed on the first impurity region 305a and on the device isolation layer 303 adjacent thereto. The bit line contact DC may be disposed in the recess region 313. A space between a lower sidewall of the bit line contact DC and an inner wall of the recess region 313 may be filled with a buried insulating pattern 316. The buried insulating pattern 316 may have a single-layer or multi-layer structure that includes (e.g., is formed of), for example, a silicon nitride layer and/or a silicon oxide layer.

Storage node contacts BC may be disposed between a pair of adjacent bit lines BL. The storage node contacts BC may be spaced apart from each other. The storage node contacts BC may include, for example, polysilicon doped with impurities. The storage node contacts BC may have island-like shapes that are spaced apart from each other when viewed in a plan view. The storage node contacts BC may extend in (e.g., may penetrate) the first insulating layer 307 and may be in contact with the second impurity regions 305b.

A storage node ohmic layer 341a may be disposed on the storage node contact BC. The storage node ohmic layer 341a may include, for example, metal silicide. As a specific example, the storage node ohmic layer 341a may include (e.g., may be) cobalt silicide.

A landing pad LP may be disposed on the storage node ohmic layer 341a. The landing pad LP may include (e.g., may be formed of), for example, a metal-containing material such as tungsten, aluminum, and copper. An upper portion of the landing pad LP may be on (e.g., may cover or overlap) an upper surface of the bit line capping pattern BLC. A center (e.g., a horizontal center) of the landing pad LP may be shifted from a center (e.g., a horizontal center) of the storage node contact BC in a direction opposite to the second direction D2. A portion of the bit line BL may vertically overlap the landing pad LP.

Neighboring (adjacent) landing pads LP may be separated by a landing pad separation pattern 347a. The landing pad separation pattern 347a may have a single-layer or multi-layer structure that includes (e.g., is formed of), for example, a silicon nitride layer, a silicon oxide layer, and/or a silicon carbonitride layer. The landing pad separation pattern 347a may extend into the second bit line capping pattern 331a and the second bit line spacer 336.

An etch stop layer EL may be disposed on the landing pads LP and the landing pad separation pattern 347a. The etch stop layer EL may include, for example, a silicon nitride layer. Lower electrodes BE may extend in (e.g., may penetrate) the etch stop layer EL and may be in contact with the landing pads LP. Some of upper side walls of the lower electrodes BE may be in contact with a support pattern SP. A dielectric layer DL may be on (e.g., may cover or overlap) (surfaces of) the lower electrodes BE and the support pattern SP. An upper electrode UE may be disposed on the dielectric layer DL. The lower electrode BE, the dielectric layer DL, and the upper electrode UE may form a capacitor CAP.

The first interlayer insulating layer IL1 may be stacked on the upper electrode UE. A second contact CT2 may extend in (e.g., may penetrate) the first interlayer insulating layer IL1 and may be in contact with the upper electrode UE. A fourth M1 wiring ML1d may be disposed on the first interlayer insulating layer IL1 and may be connected (e.g., electrically connected) to the upper electrode UE through the second contact CT2.

A peripheral gate electrode 323b may be disposed on (in) the substrate 1 in the peripheral circuit region PA. A peripheral gate insulating pattern 309b may be interposed between the peripheral gate electrode 323b and the substrate 1. A peripheral gate capping pattern 319b may be disposed on the peripheral gate electrode 323b. Peripheral source/drain regions 327 may be disposed in the substrate 1 on both (e.g., opposite) sides of the peripheral gate electrode 323b. Peripheral spacers 325 may be on (e.g., may cover or overlap) both (e.g., opposite) sides (e.g., side surfaces) of the peripheral gate electrode 323b. The peripheral gate electrode 323b may include a peripheral polysilicon pattern 311b, a peripheral ohmic pattern 315b, and a peripheral metal-containing pattern 317b that are sequentially stacked. A second insulating layer 329 may be on (e.g., may cover or overlap) the peripheral gate capping pattern 319b and the peripheral spacer 325. A third insulating layer 331 may be disposed on the second insulating layer 329.

Peripheral conductive patterns 343bw may be disposed on the third insulating layer 331. Upper surfaces of the peripheral conductive patterns 343bw may be positioned at the same height (at the same distance) as an upper surface of the landing pads LP from an upper surface of the substrate 1. First peripheral contacts 343bc may extend in (e.g., may penetrate) the third insulating layer 331 and the second insulating layer 329 and be electrically connected to the peripheral source/drain regions 327, respectively. The first peripheral contacts 343bc may be integrally connected to the peripheral conductive patterns 343bw. A peripheral ohmic layer 341b may be interposed between the first peripheral contacts 343bc and the peripheral source/drain regions 327. A fourth insulating layer 347b may be interposed between the peripheral conductive patterns 343bw. The etch stop layer EL may be on (e.g., may extend onto, cover, or overlap) the peripheral conductive patterns 343bw and the fourth insulating layer 347b. In the peripheral circuit region PA, the first interlayer insulating layer IL1 may be on (e.g., may cover or overlap) the etch stop layer EL. First contacts CT1 may extend in (e.g., may penetrate) the first interlayer insulating layer IL1 and may be in contact with the peripheral conductive patterns 343bw. First M1 wirings ML1a may be disposed on the first interlayer insulating layer IL1 and may be in contact with the first contacts CT1.

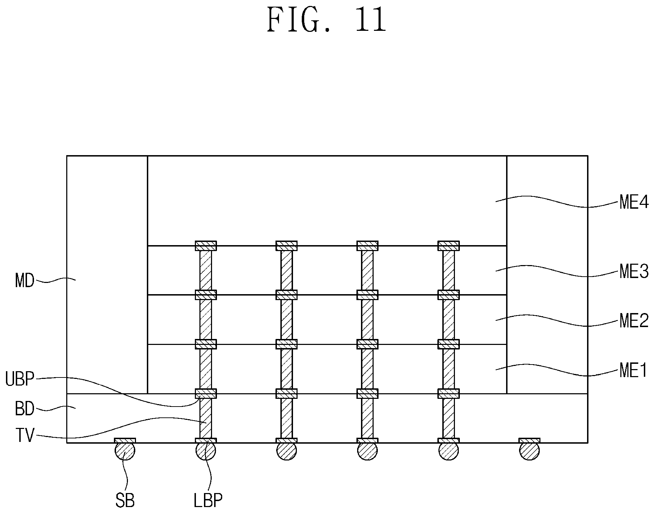

FIG. 11 is a cross-sectional view of a semiconductor package according to embodiments of the inventive concept.

Referring to FIG. 11, a semiconductor package according to the present example may be a high bandwidth memory (HBM) chip. Specifically, the semiconductor package according to the present example may include first to fourth memory dies ME1 to ME4 sequentially stacked on a buffer die BD. Each of the buffer die BD and the first to third memory dies ME1 to ME3 may include an upper bonding pad UBP, a lower bonding pad LBP, and a through via TV. Solder balls SB may be bonded to the lower bonding pad LBP of the buffer die BD. The first to fourth memory dies ME1 to ME4 may be the same memory chips and may have, for example, a DRAM structure. Each of the first to fourth memory dies ME1 to ME4 may have the structure described with reference to FIGS. 1 to 10. The lower bonding pad LBP and upper bonding pad UBP may face each other, respectively, and adjacent (corresponding) lower bonding pads LBP and upper bonding pads UBP may be bonded to each other using Cu-to-Cu bonding, such that the buffer die BD and the first to fourth memory dies ME1 to ME4 are connected (e.g., electrically connected) to each other. Although not shown, solder balls connecting (e.g., electrically connecting) the buffer die BD and the first to fourth memory dies ME1 to ME4 may be added.

As a width (in the horizontal direction) of each of the first to fourth memory dies ME1 to ME4 may be smaller than a width of the buffer die BD (in the horizontal direction), a portion of an upper surface of the buffer die BD may be exposed. A mold layer MD may be on (e.g., may cover or overlap) (the exposed portion of) the upper surface of the buffer die BD and side surfaces of the first to fourth memory dies ME1 to ME4.

In the semiconductor device and method of fabricating the same according to embodiments of the inventive concept, the second interlayer insulating layer on which the M1 wirings are disposed is in direct contact with the first interlayer insulating layer therebelow, and the layer formed of silicon nitride may not be interposed between the M1 wirings, thereby preventing/minimizing the signal interference between the M1 wirings. In addition, the adhesion between the first interlayer insulating layer and the second interlayer insulating layer may be increased, to improve the reliability of the semiconductor device and to prevent the process defects, thereby increasing the yield thereof.

## Claims

1. A semiconductor device comprising:
a substrate (1);
a first interlayer insulating layer (IL1) on the substrate (1), wherein an upper surface of the first interlayer insulating layer (IL1) is at a first distance (LV4) from an upper surface (1a) of the substrate (1);
a second interlayer insulating layer (IL2) on the first interlayer insulating layer (IL1), wherein the second interlayer insulating layer (IL2) is in direct contact with the first interlayer insulating layer (IL1);
a first contact (CT1) in the first interlayer insulating layer (IL1), wherein an upper surface of the first contact (CT1) is at a second distance (LV1) from the upper surface (1a) of the substrate (1), and the second distance (LV1) is farther than the first distance (LV4) from the upper surface (1a) of the substrate (1);
a through via (TV) in the first interlayer insulating layer (IL1) and the substrate (1), wherein an upper surface of the through via (TV) is at a third distance (LV2) from the upper surface (1a) of the substrate (1), and the third distance (LV2) is farther than the second distance (LV1) from the upper surface (1a) of the substrate (1);
a first wiring (ML1a) in the second interlayer insulating layer (IL2), wherein the first wiring (ML1a) is in contact with the first contact (CT1), a lower surface of the first wiring (ML1a) is at a fourth distance (LV5), and the fourth distance (LV5) is closer than the first distance (LV4) to the upper surface (1a) of the substrate (1); and
a second wiring (ML1c) in the second interlayer insulating layer (IL2), wherein the second wiring (ML1c) is in contact with the through via (TV), a lower surface of the second wiring (ML1c) is at a fifth distance (LV7), and the fifth distance (LV7) is closer than the fourth distance (LV5) to the upper surface (1a) of the substrate (1),
wherein the first interlayer insulating layer (IL1) includes a first material that has a first density,
wherein the second interlayer insulating layer (IL2) includes a second material that has a second density, and
wherein the first density is greater than the second density.

2. The semiconductor device of claim 1, wherein the first wiring (ML1a) has a first width (WT1) in a first direction that is parallel with the upper surface (1a) of the substrate (1),
wherein the second wiring (ML1c) has a second width (WT2) in the first direction, and
wherein the second width is greater than the first width (WT1).

3. The semiconductor device of claim 2, further comprising:
a third wiring (ML1b) in the second interlayer insulating layer (IL2),
wherein the third wiring (ML1b) is spaced apart from the first wiring (ML1a) and the second wiring (ML1c),
wherein the third wiring (ML1b) has the first width (WT1) in the first direction,
wherein a lower surface of the third wiring (ML1b) is at a sixth distance (LV6), and the sixth distance (LV6) is at a same distance as the fourth distance (LV5) from the upper surface (1a) of the substrate (1) or is closer than the fourth distance (LV5) to the upper surface (1a) of the substrate (1), and
wherein the sixth distance (LV6) is farther than the fifth distance (LV7) from the upper surface (1a) of the substrate (1).

4. The semiconductor device of claim 1, wherein the first interlayer insulating layer (IL1) is free of carbon, and
wherein the second interlayer insulating layer (IL2) includes carbon.

5. The semiconductor device of claim 1, further comprising:
a polishing stop pattern (PSP) that is in contact with a side surface of the second wiring (ML1c); and
a capping pattern (CPP) that is on the polishing stop pattern (PSP) and in contact with the side surface of the second wiring (ML1c),
wherein the upper surface of the first interlayer insulating layer (IL1) includes a protrusion (IL1_P) that extends away from the upper surface (1a) of the substrate (1) and is in contact with a lower surface of the polishing stop pattern (PSP), and
wherein the second interlayer insulating layer (IL2) is on a side surface of the protrusion (IL1_P).

6. The semiconductor device of claim 5, wherein a side surface of the capping pattern (CPP) is aligned with a side surface of the polishing stop pattern (PSP).

7. The semiconductor device of claim 5, wherein each of the capping pattern (CPP) and the polishing stop pattern (PSP) is a 'C' shape or a closed curve shape in a plan view.

8. The semiconductor device of claim 5, wherein the capping pattern (CPP) and the polishing stop pattern (PSP) are spaced apart from the first wiring (ML1a).

9. The semiconductor device of claim 5, wherein an upper surface of the polishing stop pattern (PSP) is at the third distance (LV2), and
wherein an upper surface of the capping pattern (CPP) is at a seventh distance that is farther than the third distance (LV2) from the upper surface (1a) of the substrate (1).

10. The semiconductor device of claim 1, wherein the substrate (1) includes a cell array region (CA), a peripheral circuit region (PA), and a through via region (VA),
wherein the first contact (CT1) is in the peripheral circuit region (PA),
wherein the through via (TV) is in the through via region (VA),
wherein the semiconductor device further includes:
a peripheral structure (PST) in the peripheral circuit region (PA), wherein the first interlayer insulating layer (IL1) is on the peripheral structure (PST); and
a cell structure (CST) in the cell array region (CA), wherein the first interlayer insulating layer (IL1) is on the cell structure (CST),
wherein the peripheral structure (PST) includes:
a peripheral transistor on the substrate (1); and
a peripheral contact (343bc) that is electrically connected to the peripheral transistor and is between the substrate (1) and the first contact (CT1);
wherein the cell structure (CST) includes:
a word line (WL) in the substrate (1);
a storage node contact (BC) that is in contact with the substrate (1) and is at one side of the word line (WL);
a bit line contact (DC) that is in contact with the substrate (1) and is at another side of the word line (WL);
a bit line (BL) on the bit line contact (DC), wherein the bit line (BL) overlaps the word line (WL); and
a capacitor (CAP) on the storage node contact (BC).

11. The semiconductor device of claim 1, wherein the substrate (1) includes a cell array region (CA), a peripheral circuit region (PA), and a through via region (VA),
wherein the first contact (CT1) is in the peripheral circuit region (PA),
wherein the through via (TV) is in the through via region (VA),
wherein the semiconductor device further includes:
a peripheral structure (PST) in the peripheral circuit region (PA), wherein the first interlayer insulating layer (IL1) is on the peripheral structure (PST); and
a cell structure (CST) in the cell array region (CA), wherein the first interlayer insulating layer (IL1) is on the cell structure (CST),
wherein the peripheral structure (PST) includes:
a peripheral transistor in the substrate (1); and
a peripheral contact (343bc) that is electrically connected to the peripheral transistor and is between the substrate (1) and the first contact (CT1);
wherein the cell structure (CST) includes:
a word line (WL) in the substrate (1);
a storage node contact (BC) that is in contact with the substrate (1) and is at one side of the word line (WL);
a bit line contact (DC) that is in contact with the substrate (1) and is at another side of the word line (WL);
a bit line (BL) on the bit line contact (DC), wherein the bit line (BL) overlaps the word line (WL); and
a capacitor (CAP) on the storage node contact (BC).

12. A method of fabricating a semiconductor device according to any one of claims 1 to 11, the method comprising:
forming a first interlayer insulating layer (IL1) on the substrate (1);
forming a first contact (CT1) in the first interlayer insulating layer (IL1);
forming a polishing stop layer (PSL) on the first contact (CT1) and the first interlayer insulating layer (IL1);
forming a through via hole (VH) by etching the polishing stop layer (PSL), the first interlayer insulating layer (IL1), and a portion of the substrate (1);
forming a via insulating layer (VL) and a through via (TV) in the through via hole (VH);
forming a capping layer (CPL1) on the through via (TV), the via insulating layer (VL), and the polishing stop layer (PSL);
forming a mask pattern (MK2) on the capping layer (CPL1), wherein the mask pattern (MK2) overlaps the through via (TV) and the via insulating layer (VL);
forming a capping pattern (CPP) and a polishing stop pattern (PSP) and exposing the first interlayer insulating layer (IL1) by removing portions of the capping layer (CPL1) and the polishing stop layer (PSL) that are exposed from the mask pattern (MK2);
removing the mask pattern (MK2);
forming a second interlayer insulating layer (IL2) on the first interlayer insulating layer (IL1) and the capping pattern (CPP);
forming a first trench (TC1) and a second trench (TC3) by removing at least portions of the second interlayer insulating layer (IL2), the capping pattern (CPP), and the polishing stop pattern (PSP), wherein the first trench (TC1) exposes the first contact (CT1), and the second trench (TC2) exposes the through via (TV); and
forming a first wiring (ML1a) in the first trench (TC1) and a second wiring (ML1b) in the second trench (TC3).

## Patentansprüche

1. Halbleiterbauelement, aufweisend:
ein Substrat (1);
eine erste Zwischenschicht-Isolierschicht (IL1) auf dem Substrat (1), wobei eine obere Oberfläche der ersten Zwischenschicht-Isolierschicht (IL1) einen ersten Abstand (LV4) von einer oberen Oberfläche (1a) des Substrats (1) aufweist;
eine zweite Zwischenschicht-Isolierschicht (IL2) auf der ersten Zwischenschicht-Isolierschicht (IL1), wobei die zweite Zwischenschicht-Isolierschicht (IL2) in direktem Kontakt mit der ersten Zwischenschicht-Isolierschicht (IL1) steht;
einen ersten Kontakt (CT1) in der ersten Zwischenschicht-Isolierschicht (IL1), wobei eine obere Oberfläche des ersten Kontakts (CT1) einen zweiten Abstand (LV1) von der oberen Oberfläche (1a) des Substrats (1) aufweist und der zweite Abstand (LV1) größer ist als der erste Abstand (LV4) von der oberen Oberfläche (1a) des Substrats (1);
eine Durchkontaktierung (TV) in der ersten Zwischenschicht-Isolierschicht (IL1) und dem Substrat (1), wobei eine obere Oberfläche der Durchkontaktierung (TV) einen dritten Abstand (LV2) von der oberen Oberfläche (1a) des Substrats (1) aufweist und der dritte Abstand (LV2) größer ist als der zweite Abstand (LV1) von der oberen Oberfläche (1a) des Substrats (1);
eine erste Verdrahtung (ML1a) in der zweiten Zwischenschicht-Isolierschicht (IL2), wobei die erste Verdrahtung (ML1a) mit dem ersten Kontakt (CT1) in Kontakt steht, eine untere Oberfläche der ersten Verdrahtung (ML1a) einen vierten Abstand (LV5) aufweist und der vierte Abstand (LV5) näher als der erste Abstand (LV4) zu der oberen Oberfläche (1a) des Substrats (1) ist; und
eine zweite Verdrahtung (ML1c) in der zweiten Zwischenschicht-Isolierschicht (IL2), wobei die zweite Verdrahtung (ML1c) mit der Durchkontaktierung (TV) in Kontakt steht, eine untere Oberfläche der zweiten Verdrahtung (ML1c) einen fünften Abstand (LV7) aufweist und der fünfte Abstand (LV7) näher als der vierte Abstand (LV5) zu der oberen Oberfläche (1a) des Substrats (1) ist,
wobei die erste Zwischenschicht-Isolierschicht (IL1) ein erstes Material mit einer ersten Dichte enthält,
wobei die zweite Zwischenschicht-Isolierschicht (IL2) ein zweites Material mit einer zweiten Dichte enthält und
wobei die erste Dichte größer ist als die zweite Dichte.

2. Halbleiterbauelement nach Anspruch 1, wobei die erste Verdrahtung (ML1a) eine erste Breite (WT1) in einer ersten Richtung aufweist, die parallel zu der oberen Oberfläche (1a) des Substrats (1) ist,
wobei die zweite Verdrahtung (ML1c) eine zweite Breite (WT2) in der ersten Richtung aufweist und
wobei die zweite Breite größer ist als die erste Breite (WT1).

3. Halbleiterbauelement nach Anspruch 2, ferner aufweisend:
eine dritte Verdrahtung (ML1b) in der zweiten Zwischenschicht-Isolierschicht (IL2),
wobei die dritte Verdrahtung (ML1b) von der ersten Verdrahtung (ML1a) und der zweiten Verdrahtung (ML1c) beabstandet ist,
wobei die dritte Verdrahtung (ML1b) die erste Breite (WT1) in der ersten Richtung aufweist,
wobei eine untere Oberfläche der dritten Verdrahtung (ML1b) einen sechsten Abstand (LV6) aufweist und der sechste Abstand (LV6) denselben Abstand wie der vierte Abstand (LV5) von der oberen Oberfläche (1a) des Substrats (1) aufweist oder näher als der vierte Abstand (LV5) zu der oberen Oberfläche (1a) des Substrats (1) ist, und
wobei der sechste Abstand (LV6) weiter als der fünfte Abstand (LV7) von der oberen Oberfläche (1a) des Substrats (1) entfernt ist.

4. Halbleiterbauelement nach Anspruch 1, wobei die erste Zwischenschicht-Isolierschicht (IL1) frei von Kohlenstoff ist und
wobei die zweite Zwischenschicht-Isolierschicht (IL2) Kohlenstoff enthält.

5. Halbleiterbauelement nach Anspruch 1, ferner aufweisend:
ein Polierstoppmuster (PSP), das mit einer seitlichen Oberfläche der zweiten Verdrahtung (ML1c) in Kontakt steht; und
ein Abdeckmuster (CPP), das sich auf dem Polierstoppmuster (PSP) befindet und mit der seitlichen Oberfläche der zweiten Verdrahtung (ML1c) in Kontakt steht,
wobei die obere Oberfläche der ersten Zwischenschicht-Isolierschicht (IL1) einen Vorsprung (IL1_P) beinhaltet, der sich von der oberen Oberfläche (1a) des Substrats (1) weg erstreckt und mit einer unteren Oberfläche des Polierstoppmusters (PSP) in Kontakt steht, und
wobei sich die zweite Zwischenschicht-Isolierschicht (IL2) auf einer seitlichen Oberfläche des Vorsprungs (IL1_P) befindet.

6. Halbleiterbauelement nach Anspruch 5, wobei eine seitliche Oberfläche des Abdeckmusters (CPP) nach einer seitlichen Oberfläche des Polierstoppmusters (PSP) ausgerichtet ist.

7. Halbleiterbauelement nach Anspruch 5, wobei das Abdeckmuster (CPP) und das Polierstoppmuster (PSP) in einer Draufsicht jeweils eine C-Form oder eine geschlossene Kurvenform aufweisen.

8. Halbleiterbauelement nach Anspruch 5, wobei das Abdeckmuster (CPP) und das Polierstoppmuster (PSP) von der ersten Verdrahtung (ML1a) beabstandet sind.

9. Halbleiterbauelement nach Anspruch 5, wobei eine obere Oberfläche des Polierstoppmusters (PSP) einen dritten Abstand (LV2) aufweist und
wobei eine obere Oberfläche des Abdeckmusters (CPP) einen siebten Abstand aufweist, der weiter als der dritte Abstand (LV2) von der oberen Oberfläche (1a) des Substrats (1) entfernt ist.

10. Halbleiterbauelement nach Anspruch 1, wobei das Substrat (1) einen Zellenarraybereich (CA), einen Peripherieschaltungsbereich (PA) und einen Durchkontaktierungsbereich (VA) umfasst,
wobei sich der erste Kontakt (CT1) in dem Peripherieschaltungsbereich (PA) befindet,
wobei sich die Durchkontaktierung (TV) in dem Durchkontaktierungsbereich (VA) befindet,
wobei das Halbleiterbauelement ferner umfasst:
eine Peripheriestruktur (PST) in dem Peripherieschaltungsbereich (PA), wobei sich die erste Zwischenschicht-Isolierschicht (IL1) auf der Peripheriestruktur (PST) befindet; und
eine Zellstruktur (CST) in dem Zellenarraybereich (CA), wobei sich die erste Zwischenschicht-Isolierschicht (IL1) auf der Zellstruktur (CST) befindet,
wobei die Peripheriestruktur (PST) umfasst:
einen Peripherietransistor auf dem Substrat (1); und
einen Peripheriekontakt (343bc), der mit dem Peripherietransistor elektrisch verbunden ist und sich zwischen dem Substrat (1) und dem ersten Kontakt (CT1) befindet;
wobei die Zellstruktur (CST) umfasst:
eine Wortleitung (WL) in dem Substrat (1);
einen Speicherknotenkontakt (BC), der mit dem Substrat (1) in Kontakt steht und sich auf einer Seite der Wortleitung (WL) befindet;
einen Bitleitungskontakt (DC), der mit dem Substrat (1) in Kontakt steht und sich auf einer anderen Seite der Wortleitung (WL) befindet;
eine Bitleitung (BL) auf dem Bitleitungskontakt (DC), wobei die Bitleitung (BL) die Wortleitung (WL) überlappt; und
einen Kondensator (CAP) auf dem Speicherknotenkontakt (BC).

11. Halbleiterbauelement nach Anspruch 1, wobei das Substrat (1) einen Zellenarraybereich (CA), einen Peripherieschaltungsbereich (PA) und einen Durchkontaktierungsbereich (VA) umfasst,
wobei sich der erste Kontakt (CT1) in dem Peripherieschaltungsbereich (PA) befindet,
wobei sich die Durchkontaktierung (TV) in dem Durchkontaktierungsbereich (VA) befindet,
wobei das Halbleiterbauelement ferner umfasst:
eine Peripheriestruktur (PST) in dem Peripherieschaltungsbereich (PA), wobei sich die erste Zwischenschicht-Isolierschicht (IL1) auf der Peripheriestruktur (PST) befindet; und
eine Zellstruktur (CST) in dem Zellenarraybereich (CA), wobei sich die erste Zwischenschicht-Isolierschicht (IL1) auf der Zellstruktur (CST) befindet,
wobei die Peripheriestruktur (PST) umfasst:
einen Peripherietransistor in dem Substrat (1); und
einen Peripheriekontakt (343bc), der mit dem Peripherietransistor elektrisch verbunden ist und sich zwischen dem Substrat (1) und dem ersten Kontakt (CT1) befindet;
wobei die Zellstruktur (CST) umfasst:
eine Wortleitung (WL) in dem Substrat (1);
einen Speicherknotenkontakt (BC), der mit dem Substrat (1) in Kontakt steht und sich auf einer Seite der Wortleitung (WL) befindet;
einen Bitleitungskontakt (DC), der mit dem Substrat (1) in Kontakt steht und sich auf einer anderen Seite der Wortleitung (WL) befindet;
eine Bitleitung (BL) auf dem Bitleitungskontakt (DC), wobei die Bitleitung (BL) die Wortleitung (WL) überlappt; und
einen Kondensator (CAP) auf dem Speicherknotenkontakt (BC).

12. Verfahren zur Herstellung eines Halbleiterbauelements nach einem der Ansprüche 1 bis 11, wobei das Verfahren umfasst:
Bilden einer ersten Zwischenschicht-Isolierschicht (IL1) auf dem Substrat (1);
Bilden eines ersten Kontakts (CT1) in der ersten Zwischenschicht-Isolierschicht (IL1);
Bilden einer Polierstoppschicht (PSL) auf dem ersten Kontakt (CT1) und der ersten Zwischenschicht-Isolierschicht (IL1);
Bilden eines Durchkontaktierungslochs (VH) durch Ätzen der Polierstoppschicht (PSL), der ersten Zwischenschicht-Isolierschicht (IL1) und eines Abschnitts des Substrats (1);
Bilden einer Durchkontaktierungs-Isolierschicht (VL) und einer Durchkontaktierung (TV) in dem Durchkontaktierungsloch (VH);
Bilden einer Abdeckschicht (CPL1) auf der Durchkontaktierung (TV), der Durchkontaktierungs-Isolierschicht (VL) und der Polierstoppschicht (PSL);
Bilden eines Maskenmusters (MK2) auf der Abdeckschicht (CPL1), wobei das Maskenmuster (MK2) die Durchkontaktierung (TV) und die Durchkontaktierungs-Isolierschicht (VL) überlappt;
Bilden eines Abdeckmusters (CPP) und eines Polierstoppmusters (PSP) und Freilegen der ersten Zwischenschicht-Isolierschicht (IL1) durch Entfernen von Abschnitten der Abdeckschicht (CPL1) und der Polierstoppschicht (PSL), die durch das Maskenmuster (MK2) freigelegt sind;
Entfernen des Maskenmusters (MK2);
Bilden einer zweiten Zwischenschicht-Isolierschicht (IL2) auf der ersten Zwischenschicht-Isolierschicht (IL1) und dem Abdeckmuster (CPP);
Bilden eines ersten Grabens (TC1) und eines zweiten Grabens (TC3) durch Entfernen von zumindest Abschnitten der zweiten Zwischenschicht-Isolierschicht (IL2), des Abdeckmusters (CPP) und des Polierstoppmusters (PSP), wobei der erste Graben (TC1) den ersten Kontakt (CT1) freilegt, und der zweite Graben (TC2) die Durchkontaktierung (TV) freilegt; und
Bilden einer ersten Verdrahtung (ML1a) in dem ersten Graben (TC1) und einer zweiten Verdrahtung (ML1b) in dem zweiten Graben (TC3).

## Revendications

1. Dispositif semi-conducteur comprenant :
un substrat (1) ;
une première couche isolante inter-couches (IL1) sur le substrat (1), dans lequel une surface supérieure de la première couche isolante inter-couches (IL1) est située à une première distance (LV4) d'une surface supérieure (1a) du substrat (1) ;
une deuxième couche isolante inter-couches (IL2) sur la première couche isolante inter-couches (IL1), dans lequel la deuxième couche isolante inter-couches (IL2) est en contact direct avec la première couche isolante inter-couches (IL1) ;
un premier contact (CT1) dans la première couche isolante inter-couches (IL1), dans lequel une surface supérieure du premier contact (CT1) est située à une deuxième distance (LV1) de la surface supérieure (1a) du substrat (1), la deuxième distance (LV1) étant plus grande que la première distance (LV4) ;
un via traversant (TV) dans la première couche isolante inter-couches (IL1) et le substrat (1), dans lequel une surface supérieure du via traversant (TV) est située à une troisième distance (LV2) de la surface supérieure (1a) du substrat (1), la troisième distance (LV2) étant plus grande que la deuxième distance (LV1) ;
une première ligne de métallisation (ML1a) dans la deuxième couche isolante inter-couches (IL2), dans lequel la première ligne de métallisation (ML1a) est en contact avec le premier contact (CT1), une surface inférieure de la première ligne de métallisation (ML1a) étant située à une quatrième distance (LV5), la quatrième distance (LV5) étant plus petite que la première distance (LV4) ; et
une deuxième ligne de métallisation (ML1c) dans la deuxième couche isolante inter-couches (IL2), dans lequel la deuxième ligne de métallisation (ML1c) est en contact avec le via traversant (TV), une surface inférieure de la deuxième ligne de métallisation (ML1c) étant située à une cinquième distance (LV7), la cinquième distance (LV7) étant plus petite que la quatrième distance (LV5),
dans lequel la première couche isolante inter-couches (IL1) comprend un premier matériau présentant une première densité,
dans lequel la deuxième couche isolante inter-couches (IL2) comprend un deuxième matériau présentant une deuxième densité, et
dans lequel la première densité est supérieure à la deuxième densité.

2. Dispositif semi-conducteur selon la revendication 1, dans lequel la première ligne de métallisation (ML1a) présente une première largeur (WT1) dans une première direction parallèle à la surface supérieure (1a) du substrat (1),
dans lequel la deuxième ligne de métallisation (ML1c) présente une deuxième largeur (WT2) dans la première direction, et
dans lequel la deuxième largeur est supérieure à la première largeur (WT1).

3. Dispositif semi-conducteur selon la revendication 2, comprenant en outre :
une troisième ligne de métallisation (ML1b) dans la deuxième couche isolante inter-couches (IL2),
dans lequel la troisième ligne de métallisation (ML1b) est espacée de la première ligne de métallisation (ML1a) et de la deuxième ligne de métallisation (ML1c),
dans lequel la troisième ligne de métallisation (ML1b) présente la première largeur (WT1) dans la première direction,
dans lequel une surface inférieure de la troisième ligne de métallisation (ML1b) est située à une sixième distance (LV6), la sixième distance (LV6) étant égale à la quatrième distance (LV5) ou plus petite que la quatrième distance (LV5), et
dans lequel la sixième distance (LV6) est plus grande que la cinquième distance (LV7).

4. Dispositif semi-conducteur selon la revendication 1, dans lequel la première couche isolante inter-couches (IL1) est dépourvue de carbone, et
dans lequel la deuxième couche isolante inter-couches (IL2) comprend du carbone.

5. Dispositif semi-conducteur selon la revendication 1, comprenant en outre :
un motif d'arrêt de polissage (PSP) en contact avec une surface latérale de la deuxième ligne de métallisation (ML1c) ; et
un motif de recouvrement (CPP) sur le motif d'arrêt de polissage (PSP) et en contact avec la surface latérale de la deuxième ligne de métallisation (ML1c),
dans lequel la surface supérieure de la première couche isolante inter-couches (IL1) comprend une saillie (IL1_P) qui s'étend en s'éloignant de la surface supérieure (1a) du substrat (1) et est en contact avec une surface inférieure du motif d'arrêt de polissage (PSP), et
dans lequel la deuxième couche isolante inter-couches (IL2) est sur une surface latérale de la saillie (IL1_P).

6. Dispositif semi-conducteur selon la revendicatimoon 5, dans lequel une surface latérale du motif de recouvrement (CPP) est alignée avec une surface latérale du motif d'arrêt de polissage (PSP).

7. Dispositif semi-conducteur selon la revendication 5, dans lequel chacun du motif de recouvrement (CPP) et du motif d'arrêt de polissage (PSP) présente une forme en « C » ou une forme de courbe fermée en vue en plan.

8. Dispositif semi-conducteur selon la revendication 5, dans lequel le motif de recouvrement (CPP) et le motif d'arrêt de polissage (PSP) sont espacés de la première ligne de métallisation (ML1a).

9. Dispositif semi-conducteur selon la revendication 5, dans lequel une surface supérieure du motif d'arrêt de polissage (PSP) est située à la troisième distance (LV2), et
dans lequel une surface supérieure du motif de recouvrement (CPP) est située à une septième distance, la septième distance étant plus grande que la troisième distance (LV2).

10. Dispositif semi-conducteur selon la revendication 1, dans lequel le substrat (1) comprend une région de matrice de cellules (CA), une région de circuit périphérique (PA) et une région de via traversant (VA),
dans lequel le premier contact (CT1) est dans la région de circuit périphérique (PA),
dans lequel le via traversant (TV) est dans la région de via traversant (VA),
dans lequel le dispositif semi-conducteur comprend en outre :
une structure périphérique (PST) dans la région de circuit périphérique (PA), dans lequel la première couche isolante inter-couches (IL1) est sur la structure périphérique (PST) ; et
une structure de cellule (CST) dans la région de matrice de cellules (CA), dans lequel la première couche isolante inter-couches (IL1) est sur la structure de cellule (CST),
dans lequel la structure périphérique (PST) comprend :
un transistor périphérique sur le substrat (1) ; et
un contact périphérique (343bc) électriquement connecté au transistor périphérique et situé entre le substrat (1) et le premier contact (CT1),
dans lequel la structure de cellule (CST) comprend :
une ligne de mot (WL) dans le substrat (1) ;
un contact de nœud de stockage (BC) en contact avec le substrat (1) et situé d'un côté de la ligne de mot (WL) ;
un contact de ligne de bit (DC) en contact avec le substrat (1) et situé d'un autre côté de la ligne de mot (WL) ;
une ligne de bit (BL) sur le contact de ligne de bit (DC), dans lequel la ligne de bit (BL) chevauche la ligne de mot (WL) ; et
un condensateur (CAP) sur le contact de nœud de stockage (BC).

11. Dispositif semi-conducteur selon la revendication 1, dans lequel le substrat (1) comprend une région de matrice de cellules (CA), une région de circuit périphérique (PA) et une région de via traversant (VA),
dans lequel le premier contact (CT1) est dans la région de circuit périphérique (PA),
dans lequel le via traversant (TV) est dans la région de via traversant (VA),
dans lequel le dispositif semi-conducteur comprend en outre :
une structure périphérique (PST) dans la région de circuit périphérique (PA), dans lequel la première couche isolante inter-couches (IL1) est sur la structure périphérique (PST) ; et
une structure de cellule (CST) dans la région de matrice de cellules (CA), dans lequel la première couche isolante inter-couches (IL1) est sur la structure de cellule (CST),
dans lequel la structure périphérique (PST) comprend :
un transistor périphérique dans le substrat (1) ; et
un contact périphérique (343bc) électriquement connecté au transistor périphérique et situé entre le substrat (1) et le premier contact (CT1),
dans lequel la structure de cellule (CST) comprend :
une ligne de mot (WL) dans le substrat (1) ;
un contact de nœud de stockage (BC) en contact avec le substrat (1) et situé d'un côté de la ligne de mot (WL) ;
un contact de ligne de bit (DC) en contact avec le substrat (1) et situé d'un autre côté de la ligne de mot (WL) ;
une ligne de bit (BL) sur le contact de ligne de bit (DC), dans lequel la ligne de bit (BL) chevauche la ligne de mot (WL) ; et
un condensateur (CAP) sur le contact de nœud de stockage (BC).

12. Procédé de fabrication d'un dispositif semi-conducteur selon l'une quelconque des revendications 1 à 11, le procédé comprenant :
former une première couche isolante inter-couches (IL1) sur le substrat (1) ;
former un premier contact (CT1) dans la première couche isolante inter-couches (IL1) ;
former une couche d'arrêt de polissage (PSL) sur le premier contact (CT1) et la première couche isolante inter-couches (IL1) ;
former un trou de via traversant (VH) en gravant la couche d'arrêt de polissage (PSL), la première couche isolante inter-couches (IL1) et une partie du substrat (1) ;
former une couche isolante de via (VL) et un via traversant (TV) dans le trou de via traversant (VH) ;
former une couche de coiffage (CPL1) sur le via traversant (TV), la couche isolante de via (VL) et la couche d'arrêt de polissage (PSL) ;
former un motif de masque (MK2) sur la couche de coiffage (CPL1), dans lequel le motif de masque (MK2) chevauche le via traversant (TV) et la couche isolante de via (VL) ;
former un motif de recouvrement (CPP) et un motif d'arrêt de polissage (PSP), et exposer la première couche isolante inter-couches (IL1) en enlevant des parties de la couche de coiffage (CPL1) et de la couche d'arrêt de polissage (PSL) qui sont exposées depuis le motif de masque (MK2) ;
enlever le motif de masque (MK2) ;
former une deuxième couche isolante inter-couches (IL2) sur la première couche isolante inter-couches (IL1) et le motif de recouvrement (CPP) ;
former une première tranchée (TC1) et une deuxième tranchée (TC3) en enlevant au moins des parties de la deuxième couche isolante inter-couches (IL2), du motif de recouvrement (CPP) et du motif d'arrêt de polissage (PSP), dans lequel la première tranchée (TC1) expose le premier contact (CT1), et la deuxième tranchée (TC2) expose le via traversant (TV) ; et
former une première ligne de métallisation (ML1a) dans la première tranchée (TC1) et une deuxième ligne de métallisation (ML1b) dans la deuxième tranchée (TC3).
